# EUROPÄISCHE PATENTSCHRIFT

(11) **EP 2 561 730 B1**
(45) Veröffentlichungstag und Bekanntmachung des Hinweises auf die Patenterteilung: **01.07.2015**
(21) Anmeldenummer: 11716834.4
(22) Anmeldetag: 19.04.2011
(51) Int. Cl.: H05K 1/09, H05K 3/12, H05K 3/20, G06K 19/073, G06K 19/077

(54) **TRANSFERVERFAHREN ZUR HERSTELLUNG VON LEITERSTRUKTUREN MITTELS NANOTINTEN**
TRANSFER METHOD FOR PRODUCING CONDUCTOR STRUCTURES BY MEANS OF NANO-INKS
PROCÉDÉ DE TRANSFERT PERMETTANT LA FABRICATION DE STRUCTURES CONDUCTRICES AU MOYEN DE NANO-ENCRES

(30) Priorität: 20.04.2010 DE 102010015659
(43) Veröffentlichungstag der Anmeldung: 27.02.2013
(73) Patentinhaber: Giesecke & Devrient GmbH, 81677 München (DE)
(72) Erfinder: WELLING, Ando, 84424 Isen (DE)
(86) Internationale Anmeldenummer: PCT/EP2011/001998
(87) Internationale Veröffentlichungsnummer: WO 2011/131353

(56) Entgegenhaltungen:
- EP-A2- 0 756 244
- US-A1- 2006 072 944
- US-A1- 2006 263 725

## Beschreibung

Gegenstand der vorliegenden Erfindung ist ein Verfahren zur Ausstattung eines Folienmaterials mit mindestens einer elektrisch leitfähigen Leiterstruktur, ein Verfahren zur Herstellung eines Laminatmaterials, das mindestens zwei Schichten aus Folienmaterial und mindestens eine elektrisch leitfähige Leiterstruktur zwischen den Schichten aus Folienmaterial aufweist, sowie mittels der erfindungsgemäßen Verfahren hergestellte Folienmaterialien und Laminatmaterialien mit mindestens einer elektrisch leitfähigen Leiterstruktur. Gegenstand der vorliegenden Erfindung sind auch mit dem erfindungsgemäßen Folienmaterial und Laminatmaterial hergestellte Produkte, wie beispielsweise Sicherheitsdokumente mit elektrisch leitfähigen Sicherheitsmerkmalen, und wie elektronische Schaltungseinheiten mit IC-Chip und Spule für Anwendungen wie kontaktlose Datenträger in Flachmaterialform, sowie Folienschaltelemente, die als Kartenkörper einer Chipkarte ausgebildet oder in eine Chipkarte oder in ein sonstiges Flachmaterial integriert werden können.

Die kontaktlose Datenübermittlung gewinnt zunehmend an Bedeutung, beispielsweise für Warenprüfungszwecke und Warenkontrollzwecke, zur Kennzeichnung von Waren unterschiedlichster Art zur Verhinderung von Fälschung oder Diebstahl, und insbesondere auch für elektronische Ausweise. Als Datenträger wirkt dabei typischerweise ein IC-Chip mit Antenne. Der Chip besteht aus einer Mehrzahl von elektronischen Bauteilen, und die Antenne ist eine elektrisch leitfähige Schicht, typischerweise in Spulenform. Die gespeicherte Information kann ausgelesen werden und beispielsweise auf einem Display angezeigt werden oder bestimmte mechanische Reaktionen hervorrufen, beispielsweise den Zugang zu einem bestimmten Gebäudebereich freigeben oder sperren. Es ist wünschenswert, die kontaktlosen Schaltungseinheiten möglichst klein und insbesondere flach zu halten, um sie in Form von Etiketten auf der Oberfläche von Gegenständen anbringen zu können oder als Inletts in den Schichtaufbau einer Karte, zum Beispiel eines Ausweises, oder eines sonstigen flachen Gegenstands integrieren zu können.

Eine derartige Schaltungseinheit ist beispielsweise aus der EP 0 756 244 A2 bekannt. Die offenbarte Schaltungseinheit umfasst mindestens ein isolierendes Trägersubstrat, auf dem sich eine leitende, flache Spule befindet, und einen integrierten Schaltkreis, dessen Anschlusspunkte direkt oder über Kontakte leitend mit den Spulenenden verbunden oder kapazitiv gekoppelt sind. Auf dem isolierenden Trägersubstrat sind im Wechsel Spulenlagen und isolierende Schichten aufgebracht, wobei jede isolierende Schicht wenigstens eine Durchbrechung aufweist, durch die die angrenzenden Spulenlagen leitend miteinander verbunden sind, oder wobei die angrenzenden Spulenlagen kapazitiv gekoppelt sind, so dass aus den einzelnen Spulenlagen eine Spule entsteht. Die Spulenlagen werden vorzugsweise mit einem leitenden Lack aufgedruckt oder unter Verwendung einer entsprechenden Maske aufgesprüht beziehungsweise aus einer leitenden Beschichtung, die sich auf dem Trägersubstrat befindet, ausgeätzt. Andere bekannte Herstellungsverfahren sind beispielsweise, die Spule in Form einer elektrisch leitenden Beschichtung im Heißprägeverfahren auf das Trägersubstrat aufzubringen, oder die Spule aus einer Metallfolie oder einer elektrisch leitend beschichteten Kunststoff-Folie auszustanzen und auf das Trägersubstrat aufzubringen.

Ein bevorzugtes Verfahren zur Herstellung von Spulenlagen und anderen Leiterstrukturen ist ein ätzfreies Siebdruckverfahren, bei dem eine Druckpaste mit einem leitenden Werkstoff aufgedruckt wird. Nach dem Drucken wird das Trägersubstrat einer Wärmebehandlung unterzogen, um flüchtige Bestandteile der Druckpaste zu entfernen.

Der folgende Text ist in der ursprünglichen Beschreibung auf Seite 2, Zeile 24 einzufügen. US 2006/072944 A1 (vergleiche den Oberbegriff des Anspruchs 1) offenbart ein Drucksystem für eine Leiterplatte. In einer Ausführungsform wird eine Druckeinrichtung für eine elektrofotografische Flüssigkeit beschrieben. Die Druckeinrichtung trägt eine elektrisch leitende Tinte und eine dielektrische Tinte auf ein zur Verfügung gestelltes Substrat auf, so dass eine im Wesentlichen nicht vermischbare Abgrenzung zwischen elektrisch leitender Tinte und dielektrischer Tinte entsteht. Ferner wird ein geeignetes Verfahren zur entsprechenden Behandlung einer Leiterplatte beschrieben.

US 2006/0263725 A1 beschreibt ein Verfahren zum Bilden eines Musters von elektrischen Leitern auf einem Substrat, wobei zur Herstellung des Musters metallische Nanopartikel verwendet werden. Dazu wird eine Schicht aus Trennmaterial auf einer ersten Seite eines Substrats abgeschieden. Ferner werden metallische Nanopartikel auf dem Trennmaterial abgeschieden. Auf dem Substrat wird das Muster erzeugt, indem die metallischen Nanopartikel erhitzt werden, um das Muster von elektrischen Leitern zu bilden.

Häufig ist es auch erwunscht, elektronische Funktionselemente, wie Chipmodule, zu aktivieren beziehungsweise zu deaktivieren, d.h. an- und abzuschalten. Zu diesem Zweck sind Folien-Schaltelemente beziehungsweise Folien-Taster bekannt. Zur Herstellung eines Folien-Schaltelements werden mehrere Folienschichten, zwischen denen ein Schaltkontakt hergestellt werden soll, übereinander geschichtet und miteinander verklebt. Dabei wird zwischen zwei elektrisch leitenden Schaltfolien (Kontaktfolien) eine gelochte und elektrisch isolierende Zwischenfolie angeordnet, die als Abstandshalter dient und verhindert, dass sich die Kontaktfolien im Ruhezustand des Folien-Schaltelementes berühren. Die Zwischenfolie bewirkt somit, dass das Folien-Schaltelement im Ruhezustand geöffnet ist. Durch Ausübung eines Drucks auf mindestens eine der beiden Kontaktfolien im Bereich der Lochung der Zwischenfolie wird die Kontaktfolie deformiert und ein elektrischer Kontakt zwischen den beiden Kontaktfolien hergestellt. Wenn kein Druck mehr ausgeübt wird, nimmt die Kontaktfolie in Folge ihrer Elastizität wieder ihre ursprüngliche Form an. Dadurch wird der elektrische Kontakt zwischen den beiden Kontaktfolien unterbrochen. Das Folien-Schaltelement schließt daher den Leiterkreis nur während der Ausübung eines Drucks auf mindestens eine der beiden Kontaktfolien und öffnet ihn wieder beim Nachlassen des Drucks.

Der Kontakt zwischen den Schaltfolien des "Schalters" und die Verbindung des Schalters zu den Funktionselementen wird durch elektrisch leitfähige Leiterstrukturen hergestellt. Diese Strukturen können in der gleichen Weise erzeugt werden wie die oben genannten flachen Spulen, wobei die drucktechnische Erzeugung bevorzugt ist.

Besonders bevorzugt werden zur Herstellung der Leiterstrukturen, wie Leiterbahnen, Leitflächen und Kontaktflächen, Pasten mit metallischen Partikeln verwendet, beispielsweise Silberleitpasten mit Silberpartikeln, die auf die Folien aufgedruckt werden. Dabei ergibt sich das Problem, dass Schaltungseinheiten und Folienschaltelemente, die zur Integration in Chipkarten oder für Folientastaturen oder sonstige flache Gegenstände geeignet sind, in der Regel aus Kunststoff-Folien bestehen, das heißt, die Leiterstrukturen müssen auf Kunststoff-Folien ausgebildet werden, wobei die Folien zudem häufig dünn sind mit Dicken im Bereich von etwa 50 µm bis 300 µm. Derartige Kunststoff-Folien neigen jedoch bei höheren Temperaturen dazu, sich zu verziehen, sich zu wellen und schlimmstenfalls zu schrumpfen. Diese Eigenschaft schränkt die Möglichkeiten zur Erzeugung flacher Leiterstrukturen auf Kunststoff-Folien ein. Mittels Leitpasten mit metallischen Partikeln aufgedruckte Strukturen können nur bei moderaten Temperaturen getrocknet werden, bei den üblichen Trägerfolien, wie beispielsweise PVC und amorphes PVC, bei maximal 50°C; Polycarbonat, biaxial orientiertes Polyester und Papier sind für Temperaturen von ungefähr 100°C geeignet. Gleiches gilt für Materialien auf Papierbasis, wie sie für Sicherheitspapiere und Wertdokumente, beispielsweise für Banknoten, verwendet werden. Derartige Wertdokumente weisen häufig Sicherheitsmerkmale auf, deren Prüfkriterium die elektrische Leitfähigkeit ist. Meist ist es erwünscht, die Sicherheitsmerkmale unauffällig unterzubringen. Eine Herstellung schmaler, flacher, unauffälliger Leiterstrukturen auf oder in nicht temperaturbeständigen Substraten, wie sie für Wertdokumente verwendet werden, ist jedoch praktisch unmöglich.

Bei den bei üblichen Kunststoff-Folien und Folien auf Papierbasis anwendbaren Temperaturen kann kein Versintern der die Leiterstrukturen bildenden Metallpartikel stattfinden. Die Folge ist eine im Vergleich zu massiven metallischen Leiterstrukturen schlechte elektrische Leitfähigkeit und ein hoher Metallverbrauch, um eine akzeptable Leitfähigkeit zu erzielen. Da die Leiterstrukturen bevorzugt mit Edelmetallen, wie Silber, hergestellt werden, bedingt ein hoher Metallverbrauch gleichzeitig auch hohe Kosten. Auch sind relativ hohe Leiterstrukturdicken erforderlich. Dennoch sind die erzielten elektrischen Leitfähigkeiten verbesserungsbedürftig. Mit Silberleitpasten lassen sich im günstigsten Fall Werte von etwa 1/10 der Leitfähigkeit von massivem Silber erzielen, typischerweise deutlich weniger, etwa 1/20 der Leitfähigkeit von massivem Silber.

Es besteht daher ein Bedarf an einem verbesserten Verfahren zur Erzeugung elektrischer Leiterstrukturen auf Folienmaterialien, insbesondere zur Erzeugung elektrischer Leiterstrukturen für elektronische Schaltungseinheiten und andere in Flachmaterialien, wie beispielsweise Chipkarten, integrierbare, elektrisch leitfähige Leiterstrukturen aufweisende Elemente.

Aufgabe der vorliegenden Erfindung ist es daher, ein derartiges Verfahren bereitzustellen. Das Verfahren sollte eine Kombination möglichst vieler, bevorzugt aller, der folgenden Vorteile bieten:
- es sollte die Ausbildung von Leiterstrukturen auf nicht temperaturstabilen Trägersubstraten, wie Kunststoff-Folien oder Folienmaterialien, erlauben;
- es sollte die Ausbildung von Leiterstrukturen mit einer guten elektrischen Leitfähigkeit erlauben;
- es sollte die Ausbildung flacher Leiterstrukturen erlauben;
- der erforderliche Materialverbrauch sollte gering sein;
- die Prozessdauer sollte kurz sein;
- es sollte möglich sein, die elektrische Leitfähigkeit der Leiterstrukturen vor ihrer Weiterverarbeitung zu einem Endprodukt zu prüfen.

Aufgabe der vorliegenden Erfindung ist es auch, ein Verfahren zur Herstellung eines Laminatmaterials mit elektrisch leitfähigen Leiterstrukturen, sowie die entsprechenden Folienmaterialien und Laminatmaterialien bereitzustellen.

Aufgabe der vorliegenden Erfindung ist es außerdem, Flachmaterialien mit derartigen Leiterstrukturen bereitzustellen, die mit Funktionselementen, wie einem IC-Chip ausgestattet sind oder ausgestattet werden können, und die dazu geeignet sind, in einen Kartenaufbau integriert zu werden.

Aufgabe der vorliegenden Erfindung ist es darüber hinaus, Karten mit derartigen Leiterstrukturen und elektronischen Funktionselementen bereitzustellen, wie kontaktlose Datenträger.

Die Aufgaben werden gelöst durch das Verfahren zur Ausstattung eines Folienmaterials mit mindestens einer elektrisch leitfähigen Leiterstruktur, das die Merkmale aufweist, wie sie im unabhängigen Anspruch 1 angegeben sind, durch das Verfahren zur Herstellung eines Laminatmaterials mit den Merkmalen, wie sie im unabhängigen Anspruch 9 angegeben sind, durch das Folienmaterial mit den Merkmalen, wie sie im unabhängigen Anspruch 15 angegeben sind, durch das Laminatmaterial mit den Merkmalen, wie sie im unabhängigen Anspruch 16 angegeben sind, und durch die Chipkarte und das Chipkarten-Inlett mit den Merkmalen, wie sie im unabhängigen Anspruch 19 angegeben sind. Ausgestaltungen des erfindungsgemäßen Gegenstands sind in den jeweiligen abhängigen Ansprüchen angegeben.

Der Kerngedanke der vorliegenden Erfindung liegt darin, elektrisch leitfähige Leiterstrukturen mittels sogenannter "Nanotinten" zu erzeugen, diese Leiterstrukturen aber nicht auf dem endgültigen Trägermaterial zu erzeugen, sondern auf einem temperaturstabilen Zwischenträger, und sie dann auf das endgültige Trägermaterial, das nicht temperaturstabil zu sein braucht, zu übertragen.

Wie vorstehend bereits erwähnt, bestehen Chipkarten und Laminatmaterialien mit elektronischen Schaltungseinheiten, die zur Integration in Chipkarten und andere Flachmaterialien, zum Beispiel Folientastaturen, geeignet sind, typischerweise aus Kunststoff-Folien, insbesondere aus heißlaminierbaren Kunststoff-Folien. Materialien sind beispielsweise Thermoplaste wie Polyester, Polycarbonate, Polyolefine, Polyamide, Fluorpolymere und Vinylpolymere, bevorzugt PVC. Bei der Ausbildung von elektrisch leitenden Strukturen auf den für den genannten Zweck typischerweise verwendeten Folien ist zu beachten, dass die Folien nicht temperaturstabil sind, das heißt, dass sie sich bei zu starker Erwärmung schlimmstenfalls zersetzen, zumindest aber erweichen und dabei ihre Form verlieren. Eine Verformung der Folien mit den Leiterstrukturen muss aber unbedingt vermieden werden, insbesondere, da ansonsten Passerprobleme auftreten. Ein vergleichbares Problem tritt bei Folienmaterialien aus Papier oder aus Papier/Kunststoff-Gemischen auf, wie sie für Wertdokumente, beispielsweise Banknoten, verwendet werden. Auch diese Folienmaterialien können keinen hohen Temperaturen ausgesetzt werden, ohne sich zu verändern, beispielsweise zu wellen oder sich zu zersetzen.

Ein bevorzugtes Verfahren zur Herstellung von Leiterstrukturen auf Folien für Kartenaufbauten besteht daher gegenwärtig darin, Leitpasten mit Metallpartikeln, beispielsweise mit Silberpartikeln, im Siebdruckverfahren in Form der gewünschten Leiterstrukturen auf die Folien aufzubringen, die Folien dann bei einer Temperatur bis maximal 50°C zu trocknen, typischerweise im Trockenkanal der Siebdruckanlage, und die getrockneten Folien mit Leiterstrukturen anschließend durch Heißlaminieren zu einem Laminatmaterial zu verbinden. In den fertigen Leiterstrukturen des Laminatmaterials liegen die Metallpartikel als Einzelpartikel, die einander kontaktieren, vor. Der elektrische Kontakt, und damit die elektrische Leitfähigkeit, zwischen einander kontaktierenden Einzelpartikeln ist erheblich schlechter, als dies bei einer kontinuierlichen Leiterstruktur der Fall wäre, beispielsweise bei einer aus einer massiven Metallschicht herausgeätzten Leiterstruktur. Um eine einigermaßen akzeptable Leitfähigkeit zu erzielen, müssen daher relativ dicke Leiterstrukturen ausgebildet werden. Ein hoher Materialverbrauch, und damit hohe Kosten, sind die Folge.

Erfindungsgemäß wurde nun ein Weg gefunden, trotz Verwendung nicht temperaturstabiler Trägermaterialien eine Versinterung der Metallpartikel der Leitpasten, und damit eine erheblich bessere Leitfähigkeit, zu erzielen.

Erfindungsgemäß werden als Leitpasten Nanotinten verwendet. Nanotinten sind wässrige Suspensionen oder Suspensionen auf Lösemittelbasis von metallischen Partikeln, die Partikeldurchmesser im Bereich von einigen 10 nm haben, typischerweise 20 nm bis 1000 nm. Metallische Partikel sind Partikel aus Reinmetallen oder aus Metall-Legierungen, bevorzugt Silberpartikel, Aluminiumpartikel und Partikel aus Kupfer-Nickel-Legierungen. Der Gehalt an Nanopartikeln in den Suspensionen beträgt beispielsweise 10 Gew.-% bis 30 Gew.-%, wobei der Gehalt in erster Linie durch das gewünschte Auftragungsverfahren bestimmt wird. Geeignete Auftragungsverfahren sind insbesondere Druckverfahren, bevorzugt Siebdruck, Flexodruck, Aerosoldruck, Tintenstrahldruck und Gravure-Printing. Besonders bevorzugt ist ein Siebdruckverfahren. Hierbei können relativ hohe Partikelkonzentrationen vorliegen, beispielsweise etwa 40 bis 60 Gew.-% metallische Nanopartikel.

Geeignete Nanotinten sind erhältlich von Bayer, beispielsweise die Nanosilber-Dispersion Bayink TP S mit einem Silbergehalt von 20 Gew.-% und die Nanosilber- und Nanoaluminium-Dispersionen von NovaCentrix. Die Standard-Nanosilber-Dispersionen haben Partikeldurchmesser von 25 nm beziehungsweise 35 nm. Es sind jedoch auch Dispersionen mit Partikelgrößen von 10 nm bis 100 nm erhältlich.

Die Nanopartikel haben die vorteilhafte Eigenschaft, dass sie bei wesentlich niedrigeren Temperaturen versinterbar sind als die Partikel konventioneller Leitpasten. Herkömmliche Leitpasten weisen beispielsweise eine mittlere Partikelgröße von 2 µm auf, wobei es hier große Varianzen gibt. Unter "Sintern" ist ein oberflächliches Zusammenbacken der Einzelpartikel, gegebenenfalls unter oberflächlichem Anschmelzen, zu verstehen. Durch das Zusammenbacken wird der elektrische Kontakt, und damit die elektrische Leitfähigkeit, gegenüber den einander lediglich kontaktierenden Einzelpartikeln erheblich verbessert. Es entsteht quasi ein Übergangszustand zwischen einander lediglich physisch kontaktierenden Einzelpartikeln und einer Leiterbahn aus massivem Material. Näherungsweise gilt, dass die elektrische Leitfähigkeit der Leiterstruktur um so besser wird, je höher die Sintertemperatur der Nanopartikel ist.

Silber-Nanopartikel versintern bei einer Temperatur ab etwa 150°C. Diese Sintertemperatur der Nanopartikel ist jedoch immer noch viel zu hoch, um auf Kunststoff-Folien, wie sie für Laminatmaterialien aus oder mit heißlaminierbaren Folien verwendet werden, oder auf Papier aufgedruckte Leiterstrukturen diesen Temperaturen aussetzen zu können. Die Folienmaterialien würden sich dabei dramatisch verziehen, sich wellen, oder sogar zersetzt werden. Die Zersetzung von handelsüblichen heißlaminierbaren Folien beginnt beispielsweise schon bei 160°C.

Erfindungsgemäß erfolgt die Versinterung der Nanopartikel daher nicht auf ihrem endgültigen Trägermaterial, sondern auf einem temperaturstabilen Zwischenträger. Das erfindungsgemäße Verfahren zur Ausstattung eines Folienmaterials mit Leiterstrukturen weist daher zwei grundlegende Verfahrensschritte auf, nämlich zum einen die Erzeugung der Leiterstruktur auf einem temperaturstabilen Transfermaterial, und zum anderen die Übertragung der Leiterstruktur auf das gewünschte endgültige Trägermaterial, typischerweise eine nicht temperaturstabile Folie, wobei unter einer Folie Flachmaterialien beliebiger Abmessungen, beispielsweise in Bandform oder Bahnenform, und beliebiger Zusammensetzung, typischerweise aus Kunststoffen und/oder Papier, zu verstehen sind. Die Flachmaterialien sind üblicherweise dünn, d.h. sie haben Dicken von 500 µm oder darunter, typischerweise 100 µm oder darunter.

"Nicht temperaturstabil" bedeutet, dass das endgültige Trägermaterial den Versinterungsvorgang der Nanopartikel nicht in unveränderter Form überstehen würde, sondern seine Gestalt und/oder physikalischen Eigenschaften und/oder chemischen Eigenschaften verändern würde. Ein "temperaturstabiles" Material hingegen erleidet bei den zur Versinterung erforderlichen Mindesttemperaturen von etwa 150°C keine Veränderungen.

Zur Erzeugung der Leiterstruktur oder der Leiterstrukturen auf dem temperaturstabilen Transfermaterial wird zunächst eine metallische Nanopartikel enthaltende Dispersion, im folgenden "Nanotinte" genannt, in der Form der auszubildenden Leiterstruktur auf eine Oberfläche des Transfermaterials aufgetragen, allerdings spiegelverkehrt zu der endgültigen Leiterstruktur, da der Übertragungsvorgang auf das endgültige Trägermaterial eine Spiegelung der Leiterstruktur bedingt. Dabei entsteht eine Vorläuferleiterstruktur aus metallischen Nanopartikeln, die einander berühren, zumindest nach der Entfernung des Trägermediums durch Trocknen.

Das Transfermaterial kann beispielsweise die Form eines Endlosbands haben, das im Kreis geführt und laufend wieder verwendet wird, oder es kann ein Band sein, das von einer Vorratsrolle abgewickelt und nach der Verwendung auf eine andere Vorratsrolle aufgewickelt wird, mit oder ohne Leiterstrukur(en), oder es kann die Form einer Walze oder einer Platte haben. Formen, die eine kontinuierliche Prozessführung ermöglichen, wie Bänder oder Walzen, sind bevorzugt.

Als Transfermaterialien geeignet sind Materialien, an denen einerseits die verwendeten Nanotinten nicht zu stark haften, da die versinterten Leiterstrukturen wieder von dem Transfermaterial abgelöst werden müssen, und die andererseits durch die erforderlichen Sintertemperaturen nicht beeinträchtigt werden. Elektrisch isolierend braucht das Transfermaterial nicht zu sein, da es bei der Verwendung der Leiterstrukturen ja nicht mehr vorhanden ist.

Als Transfermaterialien kommen in erster Linie Metalle, Metall-Legierungen und hochtemperaturbeständige Kunststoffe in Frage. Geeignete Metalle und Metall-Legierungen sind beispielsweise vorzugsweise Stahl oder Aluminium, auch metallisch oder mit Polymeren beschichtet, um optimierte Ablöse- bzw. Transfereigenschaften zu erzeugen. Geeignete Kunststoffe sind all jene Kunststoffe, die Dauergebrauchstemperaturen von über 150°C haben. Bevorzugt haben die Kunststoffe Dauergebrauchstemperaturen von mindestens 200°C, bevorzugter mindestens 230°C, und besonders bevorzugt von 250°C und höher. Derartige Kunststoffe sind beispielsweise einige Fluorpolymere und Polyimide, wobei Kapton (DuPont), das bis 400°C erhitzbar ist, besonders bevorzugt ist. Auch Perfluoralkoxy-Polymere, die Dauergebrauchstemperaturen bis 260°C aufweisen, sind sehr geeignet.

Auch Kombinationen von Metallen oder Metall-Legierungen und Kunststoffen können eingesetzt werden, beispielsweise Bänder oder Walzen aus Metall mit einer Kunststoff-Beschichtung oder Bänder oder Walzen aus einem anderen Material mit einer Beschichtung aus Metall oder Kunststoff. Viele hochtemperaturbeständige Kunststoffe, insbesondere perfluorierte Polymere, haben den Vorteil, dass ihre Haftkraft an anderen Materialien gering ist. Das bedeutet, dass sie gute Release-Eigenschaften für die versinterten Leiterstrukturen aufweisen, was deren Transfer erleichtert.

Die Art der Auftragung der Nanotinten ist grundsätzlich beliebig, aber bevorzugt werden die Nanotinten aufgedruckt. Die Wahl des optimalen Druckverfahrens ist in erster Linie von der Art der Nanotinte, die verwendet werden soll, bzw. deren Gehalt an Nanopartikeln abhängig. Beispiele für Nanotinten und geeignete Auftragungsverfahren wurden bereits genannt.

Die Nanotinte wird in der Form aufgetragen, die die fertige Leiterstruktur aufweisen soll. Diese wird aus der mittels der Nanotinte erzeugten Vorläuferleiterstruktur durch Versintern gebildet.

Das Versintern der Vorläuferleiterstruktur erfolgt durch Zufuhr von Wärme, d.h. durch Erhitzen der Vorläuferleiterstruktur auf eine Temperatur, die zur zumindest teilweisen Versinterung der metallischen Nanopartikel ausreicht. Die Temperatur muss daher mindestens 150°C erreichen, und da die Versinterung um so besser ist, je höher die Temperatur ist, ist es bevorzugt, bei mindestens 200°C, besonders bevorzugt mindestens 230°C, und insbesondere bei 250°C oder höher zu versintern. Die Versinterung kann beispielsweise erfolgen, indem das Transferband durch einen Ofen geführt wird, oder durch Bestrahlung mit infraroter Strahlung. Auch eine Versinterung mittels Laser ist möglich. Bei Verwendung einer Walze als Transfermaterial kommt in erster Linie IR-Versinterung oder Laserversinterung in Frage.

Da bei dem erfindungsgemäßen Verfahren relativ hohe Versinterungstemperaturen angewendet werden können, erfolgt die Versinterung innerhalb einer kurzen Zeitspanne, d.h. innerhalb von 30 Sekunden, bevorzugt innerhalb von 15 Sekunden, besonders bevorzugt in 10 Sekunden oder weniger. Bei besonders hochtemperaturbeständigen Transfermaterialien wie Kapton können Versinterungszeiten von unter 5 Sekunden erzielt werden. Die sehr geringen Versinterungszeiten bringen eine insgesamt kurze Prozessdauer mit sich.

Insbesondere bei sehr hohen Versinterungstemperaturen kann es vorteilhaft sein, die Vorläuferleiterstruktur vor dem Versinterungsprozess kurz zu trocknen, d.h. das Dispersionsmedium zu entfernen. Die Trocknung kann auf dem Weg zur Sinterstation beispielsweise durch IR-Bestrahlung erfolgen, wobei die eingestrahlte Energie geeignet zu bemessen ist, dass eine Beschädigung der Vorläufer-Leiterstruktur durch ein zu plötzlich einsetzendes Abdampfen des Dispersionsmediums vermieden wird.

Nach dem Versintern der die Vorläuferleiterstruktur bildenden metallischen Nanopartikel liegt nun eine ausgezeichnet elektrisch leitfähige Leiterstruktur auf der Oberfläche des Transfermaterials vor. In einem nächsten Schritt wird diese Leiterstruktur auf das endgültige Trägermaterial übertragen. Da es sich bei den endgültigen Trägermaterialien bevorzugt um heißlaminierbare Folien handelt, die nicht temperaturstabil sind, wird das Transfermaterial mit den darauf befindlichen Leiterstrukturen vorzugsweise auf eine Temperatur, die mit der Temperaturbeständigkeit des endgültigen Trägermaterials vereinbar ist, abgekühlt, bevor es mit dem endgültigen Trägermaterial in Kontakt gebracht wird. Vorzugsweise wird auf eine Temperatur von 50°C oder darunter abgekühlt. Das Abkühlen kann einfach dadurch erfolgen, dass das Transfermaterial zwischen Sinterstation und Übertragungsstation eine ausreichend lange Wegstrecke durchlaufen muss, oder es kann apparativ unterstützt werden, beispielsweise durch einen leichten Luftstrom.

Die auf diese Weise auf dem Transfermaterial erzeugten Leiterstrukturen weisen, bedingt durch die Versinterung der Nanopartikel, eine sehr gute elektrische Leitfähigkeit auf, die etwa im Bereich von 20 % bis 50% der Leitfähigkeit des entsprechenden massiven Materials liegt. Die Leiterstrukturen können daher sehr flach sein, das heißt Dicken im Bereich von etwa 1 bis 25 µm, bevorzugt von etwa 2 bis 10 µm, haben.

Die Leiterstrukturen werden nun von dem temperaturstabilen Transfermaterial, das elektrisch isolierend sein kann oder nicht, auf das endgültige, elektrisch isolierende Trägermaterial übertragen. Elektrisch isolierend bedeutet in diesem Zusammenhang, dass die elektrische Leitfähigkeit des endgültigen Trägermaterials im Vergleich zu den Leiterstrukturen vernachlässigbar gering ist. Das Verhältnis der Leitwerte der Leiterstrukturen zu den Leitwerten der elektrisch isolierenden Trägerfolien sollte etwa 1:1.000.000, bevorzugt 1:1.000.000.000, betragen. Die endgültigen Trägermaterialien können natürlich auch temperaturstabil sein, aber im Regelfall wird man das erfindungsgemäße Verfahren zur Anbringung von Leiterstrukturen an nicht temperaturstabilen Folienmaterialien verwenden, beispielsweise zur Anbringung von Leiterstrukturen an den zur Herstellung von Laminatmaterialien für Chipkarten beliebten heißlaminierbaren Folienmaterialien wie Polyester-, Polycarbonat-, Polyolefin-, Polyamid- und anderen thermoplastischen Folien. Ein als endgültiges Trägermaterial besonders bevorzugtes Folienmaterial ist PVC.

Die Übertragung der Leiterstrukturen von dem Transfermaterial auf das endgültige Folienmaterial kann unmittelbar nach der Herstellung der Leiterstrukturen, und gegebenenfalls Abkühlung des Transfermaterials, erfolgen. Wenn das Transfermaterial eine Walze ist oder sich in Form einer Beschichtung, Bespannung, etc. auf einer Walze befindet, ist eine sofortige Übertragung die einzig sinnvolle Möglichkeit. Bei einem Transfermaterial in Bandform oder Bahnenform oder in Form einzelner Transfermaterial-Bögen ist es jedoch auch möglich, die Übertragung zu einem späteren Zeitpunkt vorzunehmen. Das Transfermaterial mit den darauf ausgebildeten Leiterstrukturen wird dann aufgewickelt oder gestapelt und kann zwischengelagert und/oder transportiert werden. Es stellt ein Zwischenprodukt bei der Herstellung eines Folienmaterials mit elektrisch leitfähigen Leiterstrukturen dar.

Zur Übertragung einer elektrisch leitfähigen Leiterstruktur von dem Transfermaterial auf die endgültige Trägerfolie werden das Transfermaterial und die endgültige Trägerfolie so zusammengeführt, dass sich die zu übertragende Leiterstruktur zwischen einander berührenden Oberflächen von Transfermaterial und endgültiger Trägerfolie befindet. Durch Ausüben eines Drucks auf die Schicht aus Transfermaterial/Leiterstruktur/Folienmaterial wird die Leiterstruktur von dem Transfermaterial auf das Folienmaterial übertragen, da sie zu dem Folienmaterial eine größere Haftkraft aufweist als zu dem Transfermaterial. Dieser Unterschied in der Haftkraft der Leiterstrukturen zu dem Transfermaterial einerseits und dem Folienmaterial andererseits ist entscheidend für eine erfolgreiche Übertragung der Leiterstrukturen. Es werden daher bevorzugt Maßnahmen getroffen, um möglichst große Haftkraft-Unterschiede zu erzielen. Eine derartige Maßnahme ist, das Transfermaterial vor der Benutzung mit einer Tensidlösung abzuwaschen, oder es mit einer Release-Beschichtung auszustatten. Derartige Release-Beschichtungen sind bekannt. Geeignet sind beispielsweise Teflon- und Silkonbeschichtungen oder bestimmte Nanopartikelbeschichtungen. Entscheidend hierbei ist, dass die Oberflächenspannung des Substrates noch eine ausreichende Benetzbarkeit durch die Nanotinte zulässt. Eine andere Möglichkeit besteht darin, das endgültige Folienmaterial haftungsfördernd vorzubehandeln oder zu beschichten. Eine haftungsfördernde Vorbehandlung ist beispielsweise eine Corona-Behandlung, und eine haftungsfördernde Beschichtung ist eine Beschichtung mit einem Klebstoff. Geeignete Klebstoffe sind insbesondere durch Druck und/oder Wärme aktivierbare Klebstoffe, die ohne Aktivierung tackfrei sind. Tackfrei bedeutet in diesem Zusammenhang, dass das Folienmaterial mit der Klebstoffbeschichtung gerollt oder gestapelt und gelagert werden kann, ohne zu verkleben. Geeignete Klebstoffe sind beispielsweise Polyamide, Polyurethane oder Kombinationen daraus, die für eine Thermoaktivierbarkeit mit Schutzgruppen überdeckt werden. Die Maßnahmen können einzeln oder in Kombination angewendet werden.

Eine weitere Möglichkeit, die Übertragung der elektrisch leitfähigen Leiterstrukturen von dem Transfermaterial auf das endgültige Folienmaterial zu fördern, besteht darin, das Folienmaterial zu erwärmen. Erwärmte thermoplastische Folien üben auf die Leiterstrukturen eine größere Haftkraft aus als nicht erwärmte Folien, und häufig ist eine leichte Erwärmung des Folienmaterials bereits ausreichend, um eine zufriedenstellende Übertragung der Leiterstrukturen zu gewährleisten. Die Erwärmung darf natürlich nicht so stark sein, dass das Folienmaterial dadurch beeinträchtigt würde, d.h. sich verziehen oder gar zersetzen würde. Da das Folienmaterial im Moment der Übertragung räumlich fixiert ist, ist es relativ temperaturtolerant. Eine Erwärmung auf 50, 60 oder 70°C stellt meist kein Problem dar.

Eine besonders gute Haftung an dem Folienmaterial ist auch mittels spezieller Nanotinten zu erzielen, die einen Anteil an klebstoffartigen Materialien aufweisen. Geeignet sind beispielsweise Nanotinten mit Acrylat-Epoxy-Matrix.

Die Übertragung kann grundsätzlich in jeder Einrichtung erfolgen, die dazu geeignet ist, auf die zusammengeführten Materialien Druck auszuüben und ihnen gegebenenfalls Wärme zuzuführen. In Frage käme beispielsweise eine Presse, gegebenenfalls mit beheizbaren Platten, aber bevorzugt wird die Übertragung zwischen zwei Walzen durchgeführt, was eine kontinuierliche Prozessführung ermöglicht. Soll bei der Übertragung auch erwärmt werden, ist es bevorzugt, eine oder beide Walzen, insbesondere die Walze an der Seite des endgültigen Folienmaterials, beheizbar auszuführen. Wenn das Transfermaterial als Walze ausgebildet ist, stellt das Transfermaterial selbst eine der beiden Walzen, durch die das Folienmaterial zur Übertragung der Leiterstrukturen hindurchgeführt wird, dar. Ist das Transfermaterial ein Band oder eine Bahn, d.h. ein "breites" Band, auf dem mehrere Leiterstrukturen nebeneinander ausgebildet werden können, werden das Transfermaterial und das endgültige Folienmaterial in einer separaten Übertragungseinrichtung zusammengeführt. Diese Übertragungseinrichtung besteht bevorzugt aus Walze und Gegendruckwalze.

Das endgültige Folienmaterial hat bevorzugt die Form von Bändern, Bahnen oder Bögen. Es sollte natürlich mindestens so breit sein, dass alle auf dem Transfermaterial ausgebildeten Leiterstrukturen, ggf. nebeneinander ausgebildete Leiterstrukturen, vollständig übertragen werden können. Nach der Übertragung der Leiterstrukturen auf das endgültige Trägermaterial werden von diesem die Einzelnutzen der gewünschten Größe abgetrennt. Zwar ist es grundsätzlich auch möglich, die Einzelnutzen jeweils einzeln herzustellen, aber diese Herstellungsweise ist wegen ihrer Umständlichkeit und Aufwendigkeit weniger bevorzugt. Besonders bevorzugt ist es, ein bandförmiges oder bahnenförmiges Transfermaterial zu verwenden, da ein derartiges Transfermaterial die größten Freiheiten bei der Prozessführung bietet. Insbesondere können hier die Weglängen, die für die Sinterung, und gegebenenfalls für eine Vortrocknung vor dem Sintern und/oder für ein Abkühlen nach dem Sintern, erforderlich sind, je nach Bedarf frei gewählt werden. Außerdem ist es möglich, die beiden Hauptverfahrensschritte des erfindungsgemäßen Verfahrens, die Herstellung der Leiterstrukturen auf dem Transfermaterial einerseits, und die Übertragung der Leiterstrukturen auf das endgültige Folienmaterial andererseits, voneinander zu entkoppeln. Die Übertragung der Leiterstrukturen von dem Transfermaterial auf das endgültige Folienmaterial kann zeitlich und örtlich unabhängig von der Herstellung der Leiterstrukturen auf dem Transfermaterial erfolgen.

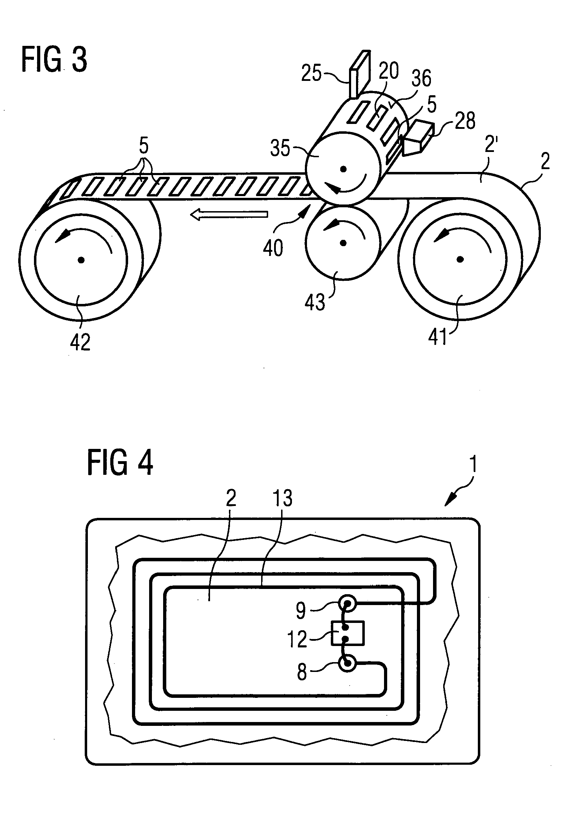

Die mit Leiterstrukturen bzw. mit mindestens einer Leiterstruktur ausgestatteten Folien können nun mit weiteren Folien, die gegebenenfalls ebenfalls eine oder mehrere Leiterstrukturen aufweisen, zu einem Laminatmaterial kombiniert werden. Einige beispielhafte Ausführungsformen erfindungsgemäßer Laminatmaterialien sind in den Figuren 4 bis 9 dargestellt. Das bevorzugte Laminierungsverfahren ist die Heißlaminierung. Bevorzugt werden zur Herstellung des Folienverbunds des Laminatmaterials ausschließlich heißlaminierbare Folien verwendet, aber es können grundsätzlich auch nicht heißlaminierbare Folien mit verwendet werden. Wenn die Folien für den durchgeführten Heißlaminierungsprozess einen zu hohen Erweichungspunkt haben, muss zwischen der entsprechenden Folie und der Nachbarfolie bzw. den Nachbarfolien ein geeigneter Klebstoff vorgesehen werden, wie ein Heißschmelzklebstoff, so dass wie beim Heißlaminieren eine stoffschlüssige Verbindung zwischen den Folien erzeugt wird. Bevorzugt werden als Deckschichten des Folienverbundmaterials Folien auflaminiert oder aufkaschiert, die als Schutzschichten dienen, die Feuchtigkeitsbeständigkeit verbessern, oder statisch aufladbar sind. Die auflaminierten oder aufkaschierten Folien können auch mit elektronischen Bauteilen oder anderen Elementen bestückt werden. Alle Materialien können nach Wunsch lichtdurchlässig oder opak und gegebenenfalls gefärbt sein. Es versteht sich, dass alle Folien, die mit Leiterstrukturen in Kontakt sind, elektrisch isolierend sein müssen. Die einzelnen Folien können sich jeweils vollflächig über das gesamte Laminatmaterial erstrecken, aber es ist auch ausreichend, wenn sie geeignete Abmessungen haben, um benachbarte Leiterstrukturen isolierend voneinander zu trennen. Das bedeutet, dass bei dem erfindungsgemäßen Verfahren zur Ausstattung eines Folienmaterials mit Leiterstrukturen dieses endgültige Folienmaterial nicht notwendigerweise vollflächig sein muss, sondern in vielen Fällen bereits die in dem späteren Laminatmaterial erwünschten durchgehenden Öffnungen aufweisen wird.

Das Laminieren erfolgt bevorzugt zwischen Laminierblechen einer Laminierpresse bei einer Temperatur, je nach Materialien, von etwa 100°C bis 150°C, kann aber beispielsweise auch zwischen zwei Laminierwalzen durchgeführt werden. Das Laminieren kann mit Laminatmaterialien in den gewünschten Endabmessungen durchgeführt werden, aber bevorzugt werden Bogenmaterialien mit einer Vielzahl von Einzelnutzen, die später auf die gewünschten Abmessungen zugeschnitten werden, miteinander laminiert. Das nach dem erfindungsgemäßen Verfahren erhaltene Folienmaterial mit Leiterstrukturen, das bevorzugt in Bandform oder Bahnenform hergestellt wird, wird dementsprechend zur Laminierung auf die gewünschten Bogenmaterial-Abmessungen zugeschnitten. Die Laminierung kann in der Weise ausgeführt werden, dass sämtliche Folien des herzustellenden Laminatmaterials in einem Arbeitsgang zu einem Folienverbund laminiert werden, oder dass zwei oder mehr Teil-Folienverbundmaterialien hergestellt werden, die dann in einem weiteren Arbeitsgang zu dem gewünschten Laminatmaterial laminiert bzw. miteinander kaschiert werden.

Die erhaltenen Laminatmaterialien können bereits fertige Karten sein, sind aber typischerweise Inletts, die in einen Kartenaufbau zu integrieren sind. Wenn ein Inlett dieselben Abmessungen wie die Karte selbst hat, erstreckt es sich über die gesamte Fläche der Karte, und es treten im Kartenaufbau keine Dickenschwankungen auf. Es ist daher bevorzugt, die erfindungsgemäßen Laminatmaterialien in den Abmessungen der Karte oder des sonstigen Flachmaterialelements, in das sie integriert werden sollen, herzustellen.

Die erfindungsgemäßen Laminatmaterialien mit Leiterstrukturen können in an sich bekannter Weise mit elektronischen Funktionselementen kombiniert werden und dann beispielsweise elektronische Schaltungseinheiten zur kontaktlosen Datenübermittlung oder Folientastaturen bilden. Insbesondere können Leiterstrukturen in einer oder in mehreren Schichten hergestellt werden, die in einer Schaltungseinheit zur kontaktlosen Datenübermittlung als Antennen wirken, oder die einen Schalter bilden und elektronische Funktionselemente in der gleichen oder in verschiedenen Ebenen eines Laminatmaterials an- beziehungsweise abschalten.

Der Aufbau derartiger Schaltungseinheiten ist hinsichtlich Materialien (selbstverständlich abgesehen von der Verwendung von Nanotinten und der Ausstattung des Folienmaterials mit Leiterstrukturen mittels Transferverfahren), hinsichtlich der erforderlichen Schichtaufbauten, gegebenenfalls hinsichtlich einer Durchkontaktierung zwischen den Schichten, und hinsichtlich der Verbindung mit elektronischen Funktionselementen an sich konventionell. Es wird diesbezüglich insbesondere auf die europäische Patentanmeldung 0 756 244 A2 verwiesen.

Die Erfindung wird nachfolgend anhand von Figuren noch weiter veranschaulicht. Es wird darauf hingewiesen, dass die Figuren nicht maßstabs- und nicht proportionsgetreu sind. Ferner sind die in einer Figur dargestellten Merkmale nicht nur in Kombination mit den übrigen in der entsprechenden Figur dargestellten Merkmalen anwendbar. Vielmehr können im Zusammenhang mit einer speziellen Ausführungsform beschriebene Merkmale ganz allgemein bei dem erfindungsgemäßen Laminatmaterial zur Anwendung kommen. Gleiche Bezugsziffern bezeichnen gleiche oder entsprechende Elemente. Es zeigen:
- Fig. 1: ein erfindungsgemäßes Laminatmaterial in Aufsicht,
- Fig. 2: eine schematische Darstellung einer Ausführungsform einer Einrichtung zur Durchführung des erfindungsgemäßen Verfahrens zur Ausstattung eines Folienmaterials mit mindestens einer elektrisch leitfähigen Leiterstruktur,
- Fig. 3: eine schematische Darstellung einer anderen Ausführungsform einer Einrichtung zur Durchführung des erfindungsgemäßen Verfahrens zur Ausstattung eines Folienmaterials mit mindestens einer elektrisch leitfähigen Leiterstruktur,
- Fig. 4: eine erfindungsgemäße Chipkarte in Aufsicht,
- Fig. 5: die Chipkarte von Fig. 4 in perspektivischer Sicht,
- Fig. 6: einen Querschnitt entlang der Linie A-A der Fig. 5,
- Fig. 7: eine Teilschnittansicht eines erfindungsgemäßen Laminatmaterials mit einem Schalter als Explosionsdarstellung,
- Fig. 8a, 9a: jeweils Aufsichten von unten auf eine Leiterstruktur des Schalters von Fig. 7, und
- Fig. 8b, 9b: jeweils Aufsichten von oben auf der Leiterstruktur von Fig. 8a, 9a gegenüberliegende Leiterstrukturen des Schalters von Fig. 7.

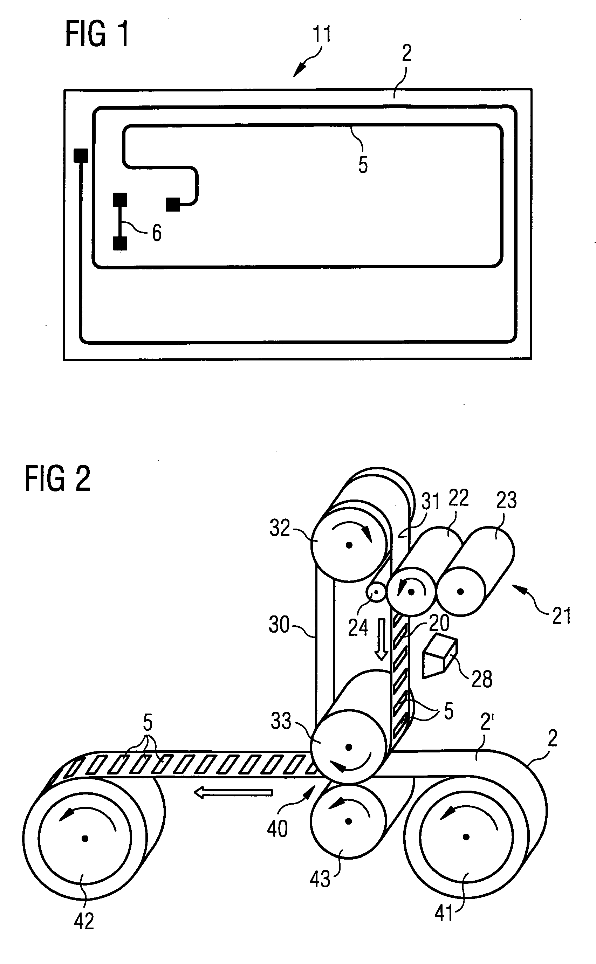

Fig. 1 zeigt ein erfindungsgemäßes Laminatmaterial 11 in Aufsicht. Das Laminatmaterial 11 weist eine Schicht aus einem ersten Folienmaterial 2, d.h. eine erste Folienschicht 2, und eine Schicht aus einem zweiten Folienmaterial, d.h. eine zweite Folienschicht, auf. Die zweite Folienschicht ist transparent und daher in der Figur nicht erkennbar, so dass eine erste Leiterstruktur 5 und eine zweite Leiterstruktur 6 zwischen den Folienschichten sichtbar sind. Die Leiterstruktur 5 ist mit der Leiterstruktur 6 verbunden, beispielsweise ist die Leiterstruktur 6 mit dem linken Ende der Leiterstruktur 5 verbunden. Die Enden der Leiterstrukturen 5, 6 zum Verbinden mit einem elektronischen Funktionselement, wie einem IC-Chip, sind jeweils verbreitert dargestellt. Die IC-Chips selbst sind in der schematischen Darstellung weggelassen. Die erste Leiterstruktur 5 ist eine Leiterbahn in Form einer Spule, wie sie für Datenträger zum kontaktlosen Datenaustausch oder zur kontaktlosen Energieversorgung benötigt wird. Zur Herstellung des Laminatmaterials 11 wird eine Nanotinte, beispielsweise eine Suspension mit Silber-Nanopartikeln, auf eine Oberfläche eines Transfermaterials aufgedruckt, beispielsweise im Siebdruckverfahren oder Flexodruckverfahren. Die Nanotinte wird jeweils in einer Gestalt aufgetragen, die der Gestalt der gewünschten Leiterstrukturen 5, 6 entspricht. Dabei werden Vorläufer-Leiterstrukturen ausgebildet, die aus Einzel-Nanopartikeln bestehen. Das Transfermaterial mit den Vorläufer-Leiterstrukturen wird nun getrocknet, bevorzugt durch Verdunstenlassen des Trägermediums der Nanotinte während des Transports des Transfermaterials mit den Vorläufer-Leiterstrukturen zur Sinterstation.

In der Sinterstation, beispielsweise einem Tunnelofen, durch den das Transfermaterial hindurchgeführt wird, werden die Silber-Nanopartikel bei einer Temperatur von beispielsweise 250°C einem Sinterprozess unterzogen. Dabei entsteht aus der ersten Vorläufer-Leiterstruktur die erste Leiterstruktur 5, und aus der zweiten Vorläufer-Leiterstruktur entsteht die zweite Leiterstruktur 6. Anschließend lässt man das Transfermaterial mit den Leiterstrukturen 5, 6 abkühlen und dann wird es mit dem ersten Folienmaterial 2 zusammengeführt. Das Zusammenführen erfolgt beispielsweise im Walzenspalt von zwei eine Übertragungsstation bildenden Walzen. In dem Walzenspalt werden die Leiterstrukturen 5, 6 von dem Transfermaterial auf das erste Folienmaterial 2 übertragen. Das erste Folienmaterial 2 wird dann an der Oberfläche, auf der sich nun die Leiterstrukturen 5, 6 befinden, mit einem zweiten Folienmaterial bedeckt, und die beiden Folienmaterialien zu dem Laminatmaterial 11 laminiert. In dem Folienmaterial 11 sind die Leiterstrukturen 5, 6 zwischen der ersten Folienschicht 2 aus dem ersten Folienmaterial und der zweiten Folienschicht aus dem zweiten Folienmaterial geschützt eingeschlossen.

Fig. 2 veranschaulicht die Durchführung des erfindungsgemäßen Verfahrens. Ein Transfermaterial-Band 30 mit einer Oberfläche 31 wird von Transportrollen 32, 33, die mittels eines nicht gezeigten Antriebs angetrieben werden, im Kreis geführt. Das Transportmaterial-Band besteht beispielsweise aus einem hochtemperaturbeständigen Kunststoff wie Kapton. Die Pfeile in den Rollen 32, 33 geben den Drehsinn der Rollen an. Ein Flexodruckwerk 21 ist schematisch durch einen Druckzylinder 22 mit Klischees, eine Nanotinten-Übertragungswalze 23 und eine Gegendruckwalze 24 angedeutet. Mittels des Druckwerks 21 werden Vorläufer-Leiterstrukturen 20 auf die Oberfläche 31 des Transfermaterial-Bands 30 aufgedruckt. Die Vorläufer-Leiterstrukturen 20 werden in der Form und Anordnung aufgedruckt, in der sie später auf dem endgültigen Trägermaterial vorliegen sollen, allerdings spiegelverkehrt, da der Übertragungsvorgang auf das endgültige Trägermaterial eine Spiegelung der Strukturen bedingt. In Fig. 2 sind die Vorläuferleiterstrukturen 20 schematisch als Rechtecke gezeichnet, aber die Strukturen können natürlich beliebige Formen haben. Es können auch mehrere Vorläufer-Leiterstrukturen 20 nebeneinander angeordnet sein, was eine entsprechend größere Breite des Transfermaterial-Bands 30 erfordert, d.h. eine Transfermaterial-Bahn.

Das Transfermaterial 30 wird kontinuierlich in Pfeilrichtung transportiert, wodurch die Vorläufer-Leiterstrukturen 20 eine Sinterstation 28 erreichen. Die Sinterstation 28 ist beispielsweise ein Tunnelofen, durch den das Transfermaterial-Band hindurchgeführt wird, oder ein IR-Strahler oder eine sonstige Wärmequelle. Vor dem Erreichen der Sinterstation 28 bestehen die Vorläufer-Leiterstrukturen 20 aus metallischen Nanopartikeln in einem Trägermedium, wobei das Trägermedium auf dem Transportweg zwischen Druckwerk 21 und Sinterstation 28 in mehr oder weniger starkem Ausmaß verdunstet. Wenn eine vollständige Verdunstung gewünscht wird, kann für einen ausreichend langen Transportweg gesorgt werden, beispielsweise durch eine meanderförmige Bahnführung des Transfermaterial-Bands 30 oder durch eine zusätzliche Wärmequelle zwischen Druckwerk 21 und Sinterstation 28. In der Sinterstation 28 werden die Vorläufer-Leiterstrukturen 20 auf eine Temperatur erhitzt, die zur Versinterung der metallischen Nanopartikel ausreicht. Bevorzugt wird die Obergrenze der Dauergebrauchstemperatur des Transfermaterials als Sintertemperatur gewählt, da die Versinterung, und damit die Leitfähigkeit der endgültigen Leiterstrukturen um so besser ist, je höher die Sintertemperaturen sind. Auch ist die Versinterungszeit um so kürzer, je höher die Sintertemperatur ist. Bei Silber-Nanopartikeln und einer Sintertemperatur von etwa 250°C nimmt der Sintervorgang nur wenige Sekunden in Anspruch. Nach dem Versintern liegen nicht mehr, wie in den Vorläufer-Leiterstrukturen 20, einander lediglich physisch kontaktierende metallische Nanopartikel vor, sondern es haben sich durchgehende metallische Strukturen mit entsprechend guter Leitfähigkeit ausgebildet.

Diese "fertigen" Leiterstrukturen 5 werden nun weiter transportiert, um auf ihr endgültiges Trägermaterial übertragen zu werden. Das endgültige Trägermaterial 2, beispielsweise eine PVC-Folie, ist nicht temperaturstabil, weshalb das Transfermaterial-Band 30 mit den Leiterstrukturen 5 vor dem Kontakt mit dem endgültigen Trägermaterial 2 ausreichend abgekühlt sein muss. Das Abkühlen erfolgt entweder automatisch auf dem Transportweg oder durch eine (nicht gezeigte) Kühleinrichtung zwischen der Sinterstation 28 und der Übertragungsstation 40. Bei der dargestellten Ausführungsform besteht die Übertragungsstation 40 aus der Transportrolle 33 des Transfermaterial-Bands 30 und einer Gegendruckwalze 43. Das Folienmaterial 2, auf dessen Oberfläche 2' die Leiterstrukturen 5 übertragen werden sollen, befindet sich auf einer Vorratsrolle 41, wird von dieser Vorratsrolle abgewickelt und durch den Walzenspalt der Übertragungsstation 40 geführt, und schließlich auf einer weiteren Rolle 42 wieder aufgewickelt. Die Pfeile geben jeweils die Bewegungsrichtungen an. Das Folienmaterial 2 hat zweckmäßigerweise etwa dieselbe Breite wie das Transfermaterial-Band 30, in der dargestellten Ausführungsform eine Breite, die keine Nebeneinander-Anordnung von Vorläufer-Leiterstrukturen 20 bzw. Leiterstrukturen 5 erlaubt. Das Folienmaterial 2 ist als durchgehende Folie dargestellt, aber das Folienmaterial kann auch durchgehende Öffnungen aufweisen, je nach späterem Verwendungszweck.

Das Transfermaterial-Band 30 mit den Leiterstrukturen 5 auf seiner Oberfläche 31 und das Folienmaterial 2 werden im Walzenspalt der Übertragungsstation 40 so miteinander in Kontakt gebracht, dass die Leiterstrukturen 5 die Oberfläche 2' des Folienmaterials 2 berühren. Durch den im Walzenspalt ausgeübten Druck werden sie an die Oberfläche 2' angepresst und bleiben an ihr haften. Diese Haftung wird unterstützt durch eine beheizte Gegendruckwalze 43, die das Folienmaterial 2 leicht erwärmt, beispielsweise auf eine Temperatur von etwa 50°C, und der Oberfläche 2' dadurch eine größere Haftkraft verleiht. Wenn das Folienmaterial 2 und das Transfermaterial-Band 30 nach dem Verlassen des Walzenspalts wieder voneinander getrennt werden, befinden sich die Leiterstrukturen 5 auf der Oberfläche 2' der PVC-Folie, während das Transfermaterial-Band 30 wieder leiterstrukturfrei ist und erneut mit Vorläufer-Leiterstrukturen 20 bedruckt werden kann. Die mit Leiterstrukturen 5 ausgestattete PVC-Folie 2 wird auf die Vorratsrolle 42 aufgewickelt oder, alternativ, unmittelbar nach der Ausstattung mit Leiterstrukturen 5 in Teilstücke mit Abmessungen zugeschnitten, wie sie für die spätere Laminierung zu einem Laminatmaterial geeignet sind.

In der in Fig. 2 dargestellten Ausführungsform hat das Transfermaterial 30 die Form eines Endlosbands, was bedingt, dass die Herstellung der Leiterstrukturen 5 auf dem Transfermaterial 30 und ihre Übertragung auf das Folienmaterial 2 sinnvollerweise unmittelbar nacheinander, d.h. in einer kombinierten Anlage, durchgeführt werden müssen. Alternativ ist es jedoch auch möglich, das Transfermaterial-Band 30 ähnlich wie das Folienmaterial 2 von einer Vorratsrolle zuzuführen, darauf die Leiterstrukturen 5 auszubilden, und dann das mit den Leiterstrukturen 5 ausgestattete Transfermaterial-Band wieder auf eine Vorratsrolle aufzuwickeln, um es erst zu einem späteren Zeitpunkt und in einer anderen Anlage zur Übertragung der Leiterstrukturen 5 auf ein Folienmaterial 2 zu verwenden. Bei einer solchen Ausführungsform würde das Transfermaterial-Band 30 der Transportrolle 32 von einer Transfermaterial-Vorratsrolle zugeführt werden, und statt oder nach der Transportrolle 33 gäbe es eine weitere Vorratsrolle, auf die das Transfermaterial-Band mit den fertigen Leiterstrukturen 5 aufgewickelt würde.

Das Folienmaterial 2 kann auch an seinen beiden Oberflächen mit Leiterstrukturen ausgestattet werden. Zu diesem Zweck könnte beispielsweise die Gegendruckwalze 43 durch eine weitere Anordnung aus Transfermaterial, Druckwerk und Sinterstation ersetzt werden.

Fig. 3 zeigt eine alternative Ausführungsform des Transfermaterials. In der in Fig. 3 dargestellten Ausführungsform hat das Transfermaterial die Form einer Walze 35 mit einer Oberfläche 36, auf die die Vorläufer-Leiterstrukturen 20 aufgedruckt werden. Die Walze 35 kann beispielsweise aus Metall oder aus einem hochtemperaturbeständigen Kunststoff, wie Kapton, bestehen, oder es kann auch eine Metallwalze verwendet werden, die mit einem hochtemperaturbeständigen Kunststoff beschichtet ist. Die Transfermaterial-Walze wird mittels eines nicht gezeigten Antriebs gedreht. Anstelle des Flexodruckwerks 21 der Fig. 2 wird bei der Ausführungsform der Fig. 3 ein Tintenstrahldrucker verwendet, der schematisch als Druckkopf 25 angedeutet ist. Die Verwendung eines walzenförmigen Transfermaterials erlaubt weniger Freiheitsgrade bei der Durchführung des Verfahrens als die Verwendung eines bandförmigen oder bahnförmigen Transfermaterials. Wie aus Fig. 3 unmittelbar ersichtlich ist, bildet die Transfermaterial-Walze 35 einen Teil der Übertragungsstation 40 (gemeinsam mit der Gegendruckwalze 43), so dass es nicht möglich ist, die Herstellung der Leiterstrukturen 5 und ihre Übertragung auf das Folienmaterial 2 zeitlich und räumlich zu entkoppeln. Außerdem sind die Transportwege zwischen Drucker 25 und Sinterstation 28, sowie zwischen Sinterstation 28 und Übertragungsstation 40 durch den Umfang der Walze 35 festgelegt. Als Wärmequelle zum Versintern kommt im wesentlichen eine Strahlungsquelle in Betracht. Ansonsten entspricht die in Fig. 3 dargestellte Ausführungsform der in Fig. 2 dargestellten Ausführungsform.

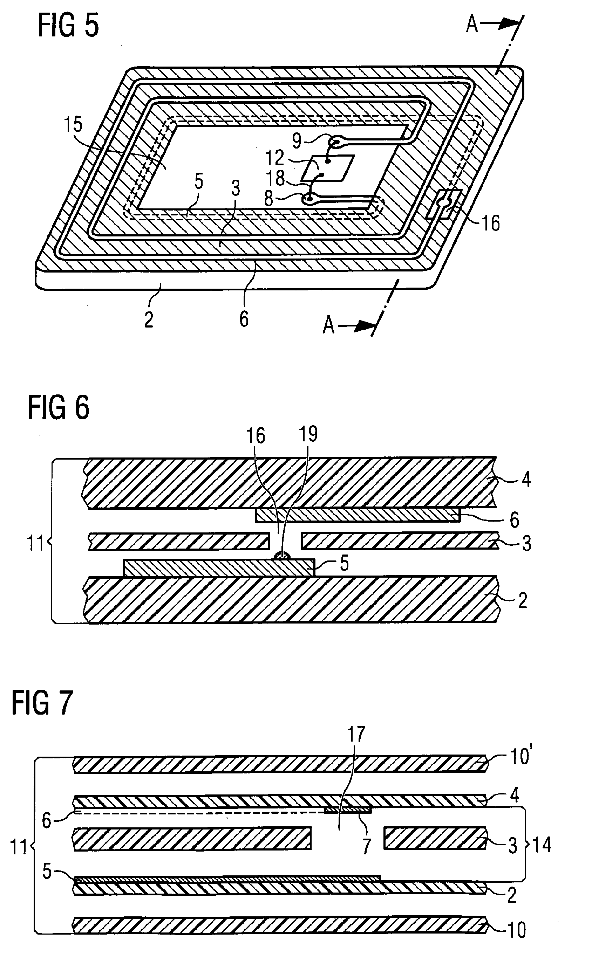

Die Figuren 4 und 5 zeigen eine Chipkarte 1 in Aufsicht bzw. in perspektivischer Sicht. Die Chipkarte 1 weist ebenfalls eine Spule auf, wie die durch die erste Leiterstruktur 5 gebildete Spule in Fig. 1. Die Spule 13 der Chipkarte 1 besteht jedoch aus zwei Spulenlagen, die durch eine isolierende Folienschicht getrennt werden. Die Chipkarte 1 weist eine Schicht aus einem ersten Folienmaterial 2, d.h. eine erste Folienschicht 2, eine Schicht aus einem zweiten Folienmaterial 3, d.h. eine zweite Folienschicht 3, und eine Schicht aus einem dritten Folienmaterial, d.h. eine dritte Folienschicht, die in Fig. 4 und 5 nicht dargestellt ist, auf. Die Folienschichten sind jeweils elektrisch isolierende Kunststoff-Folien. Zwischen der ersten Folienschicht 2 und der zweiten Folienschicht 3 befindet sich die erste Leiterstruktur 5, die eine erste Spulenlage bildet, und zwischen der zweiten Folienschicht 3 und der dritten Folienschicht befindet sich eine zweite Leiterstruktur 6, die eine zweite Spulenlage bildet. Die zweite Folienschicht 3 weist durchgehende Öffnungen 15, 16 auf. Die Öffnung 16 dient dazu, die erste Leiterstruktur 5 und die zweite Leiterstruktur 6 elektrisch leitend miteinander zu verbinden, wie noch genauer bei Fig. 6 erläutert wird. Dadurch entsteht die "zweilagige" Spule 13. Das Kontaktfenster 16 in der Zwischenschicht 3 kann jedoch auch entfallen. Dann besteht zwischen den beiden Spulenlagen keine elektrisch leitende Verbindung. Die Spulenlagen sind stattdessen kapazitiv gekoppelt.

Die durchgehende Öffnung 15 im mittigen Bereich der Folienschicht 3 dient dazu, eine elektrisch leitende Verbindung zwischen den Enden 8, 9 der Spule 13 und einem IC-Chip 12 herzustellen. Insbesondere befindet sich das Ende 8 der ersten Leiterstruktur 5 auf der ersten Folienschicht 2, und es würde von einer Folienschicht 3 ohne durchgehende Öffnung 15 abgedeckt werden. Bei der dargestellten Ausführungsform sind die Abmessungen der zweiten Folienschicht bzw. der Zwischenschicht 3 so gewählt, dass die zweite Folienschicht 3 lediglich die erste Leiterstruktur 5 und die zweite Leiterstruktur 6 voneinander isoliert, den mittigen Bereich der ersten Folienschicht 2 aber nicht bedeckt. Der IC-Chip 12 befindet sich in der dargestellten Ausführungsform dementsprechend auf einer Oberfläche der ersten Folienschicht 2. Er ist in an sich bekannter Weise über Bonddrähtchen 18 mit dem ersten Leiterstrukturende 8 und dem zweiten Leiterstrukturende 9 verbunden. Alternativ kann allerdings auch die zweite Folienschicht 3 vollflächig ausgebildet werden. In diesem Fall ist auch der integrierte Schaltkreis 12 kapazitiv an die Spule 13 gekoppelt, analog der kapazitiven Kopplung der ersten und der zweiten Spulenlage bei Fehlen des Kontaktfensters 16.

Die Herstellung der Chipkarte 1 erfolgt durch Ausstatten des ersten Folienmaterials 2 mit der ersten Leiterstruktur 5 nach dem oben beschriebenen erfindungsgemäßen Sinter/Transferverfahren, Ausstatten des zweiten Folienmaterials 3 oder des dritten Folienmaterials mit der zweiten Leiterstruktur 6 nach dem oben beschriebenen erfindungsgemäßen Sinter/Transferverfahren, Stapeln der Folienmaterialien in der Weise, dass sich die erste Leiterstruktur 5 zwischen dem ersten Folienmaterial 2 und dem zweiten Folienmaterial 3 befindet und sich die zweite Leiterstruktur 6 zwischen dem zweiten Folienmaterial 3 und dem dritten Folienmaterial befindet, und Heißlaminieren des Folienstapels zu der Chipkarte 1.

Wenn sich die zweite Leiterstruktur 6 auf dem zweiten Folienmaterial 3 befindet, kann kein Kontaktfenster 16 vorgesehen werden, und die Spulenlagen sind kapazitiv gekoppelt. Wenn sich die zweite Leiterstruktur 6 auf dem dritten Folienmaterial befindet, kann das zweite Folienmaterial 3 das Kontaktfenster 16 aufweisen, und es kann zwischen den Leiterstrukturen 5, 6 eine elektrisch leitende Verbindung ausgebildet werden, wie in Fig. 6 dargestellt.

Fig. 6 zeigt einen Querschnitt entlang der Linie A-A der Fig. 5. Der Querschnitt verdeutlicht den Schichtaufbau der Chipkarte und die elektrisch leitende Verbindung zwischen den Spulenlagen 5, 6 durch das Kontaktfenster 16 der Zwischenschicht 3. Die Spulenlagen 5, 6 überlappen einander im Bereich des Kontaktfensters 16, und beim Stapeln des ersten Folienmaterials 2, des zweiten Folienmaterials 3 und des dritten Folienmaterials 4, um die Schichten zu dem Laminatmaterial 11 zu laminieren, wird eine kleine Menge Leitkleber 19 im Bereich des Kontaktfensters 16 auf eine der Spulenlagen 5, 6 aufgebracht. Beim Laminieren fließt der Leitkleber 19 in das Kontaktfenster 16 und stellt eine elektrisch leitende Verbindung zwischen den Leiterstrukturen 5, 6 her.

Die dargestellte Chipkarte 1 weist lediglich drei Folienschichten auf. Es können aber selbstverständlich weitere Folienschichten auflaminiert oder aufkaschiert werden, wobei diese weiteren Folienschichten ebenfalls elektrisch leitfähige Leiterstrukturen aufweisen können, die gemäß dem oben beschriebenen erfindungsgemäßen Sinter/Transferverfahren oder nach einem anderen Verfahren hergestellt sind. Diese weiteren Folienschichten können gleichzeitig mit den übrigen Folienschichten heißlaminiert werden, oder das Heißlaminieren kann in mehreren Schritten, d.h. an Teil-Folienstapeln, durchgeführt werden.

Die dargestellten Laminatmaterialien mit Leiterstrukturen aus versinterten metallischen Nanopartikeln, kombiniert mit einem elektronischen Funktionselement oder mehreren elektronischen Funktionselementen, werden typischerweise als Inletts in den Schichtaufbau einer Karte integriert. Alternativ kann auch bereits der endgültige Kartenaufbau in der angegebenen Weise durch Ausstatten von Folienmaterialien mit Leiterstrukturen und anschließendes Laminieren der Folienmaterialien hergestellt werden.

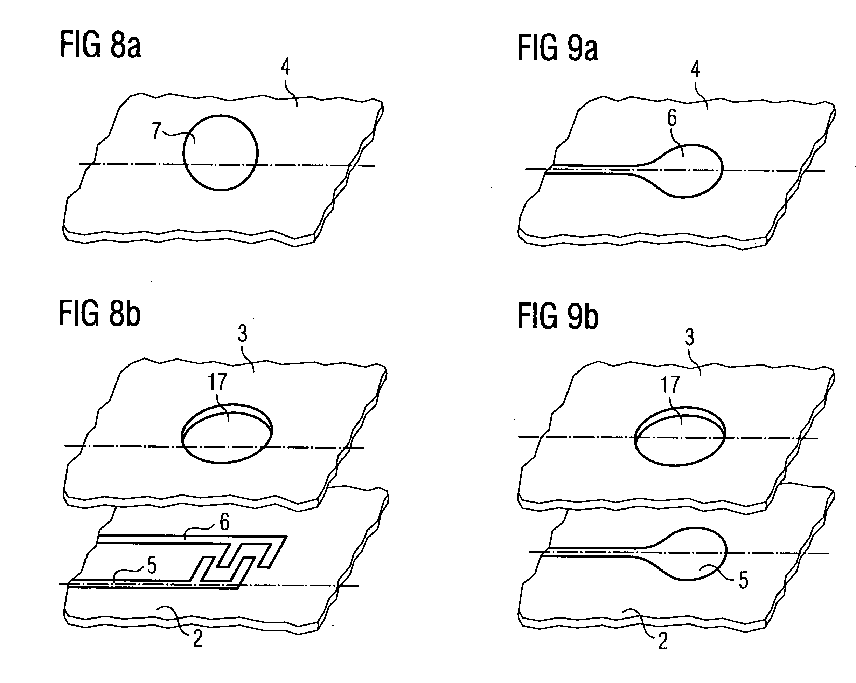

Fig. 7 zeigt eine Teilschnittansicht eines erfindungsgemäßen Laminatmaterials 11 mit einem Schalter 14. Die Folienschichten sind im Zustand vor dem Laminieren, aber in der erforderlichen Schichtfolge und Orientierung zueinander, dargestellt. Das Laminatmaterial 11 weist eine erste Folienschicht 2, eine zweite Folienschicht 3 und eine dritte Folienschicht 4, sowie weitere Folienschichten 10, 10' auf. Auf einer Oberfläche der Folienschicht 2 befindet sich eine mittels des erfindungsgemäßen Sinter/Transferverfahrens hergestellte erste Leiterstruktur 5. Auf einer Oberfläche der Folienschicht 4 befindet sich eine ebenfalls mittels des erfindungsgemäßen Sinter/Transferverfahrens hergestellte weitere Leiterstruktur, die verschiedene Gestalten haben kann, wie in Fig. 8a und Fig. 9a gezeigt. Fig. 8a zeigt eine Leiterstruktur 7 in Form einer Leitfläche ohne irgendeine Verbindung zu anderen Leiterstrukturen, und Fig. 9a zeigt eine Leiterstruktur 6, die eine Kombination aus Leitfläche und Leiterbahn ist. In Fig. 7 ist die Leiterstruktur 7 mit durchgehenden Linien dargestellt, während die Leiterstruktur 6 mit gestrichelten Linien als Verlängerung der Leiterstruktur 7 dargestellt ist. Die Figuren 8a, 9a zeigen jeweils Aufsichten von unten auf die Leiterstrukturen 7 beziehungsweise 6. Die Figuren 8b und 9b zeigen jeweils Aufsichten von oben auf die den Leiterstrukturen 7 beziehungsweise 6 gegenüberliegenden Leiterstrukturen, die sich an einer Oberfläche der Folie 2 befinden. In den Figuren 8b, 9b ist jeweils auch die Zwischenschicht 3 dargestellt, die die Leiterstrukturen auf den Folien 2 und 4, den "Kontaktfolien", voneinander trennt, jedoch eine durchgehende Öffnung 17 aufweist, durch die die gegenüberliegenden Leiterstrukturen miteinander in Kontakt kommen können. Der Kontakt wird durch Ausübung eines Drucks auf die elastischen Kontaktfolien des Laminatmaterials 11 im Bereich der durchgehenden Öffnung 17 (des Schaltfensters 17) hergestellt, und durch Beenden des Druck wieder unterbrochen. Wenn kein Druck mehr ausgeübt wird, kehren die elastischen Folien wieder in ihren Ausgangszustand zurück. Mit dieser Anordnung können elektronische Funktionselemente an- und abgeschaltet werden. Je nachdem, ob ein Kontakt zwischen verschiedenen Ebenen des Laminatmaterials hergestellt beziehungsweise unterbrochen werden soll, oder ob ein Kontakt in derselben Ebene hergestellt oder unterbrochen werden soll, sind die Leiterstrukturen unterschiedlich gestaltet.

Fig. 8 betrifft die Herstellung/Unterbrechung eines elektrischen Kontakts zwischen Leiterstrukturen in derselben Ebene. Eine erste Leiterstruktur 5 und eine zweite Leiterstruktur 6 (Fig. 8b) können mittels einer dritten Leiterstruktur 7 (Fig. 8a) elektrisch leitend miteinander verbunden werden.

Fig. 9 betrifft die Herstellung/Unterbrechung eines elektrischen Kontakts zwischen Leiterstrukturen in verschiedenen Ebenen. Eine erste Leiterstruktur 5 (Fig. 9b) kann mit einer zweiten Leiterstruktur 6 (Fig. 9a) elektrisch leitend verbunden werden. Die Leiterstrukturen 5, 6 und 7 (Fig. 8) und die Leiterstrukturen 5 und 6 (Fig. 9) bilden jeweils zusammen einen Schalter 14. Die Herstellung eines derartigen Laminatmaterials 11 mit einem Schalter 14 erfolgt wiederum durch Ausstatten von Folienmaterialien 2 und 4 mit den entsprechenden Leiterstrukturen 5, 6 und 7 (Fig. 8) bzw. mit den Leiterstrukturen 5 und 6 (Fig. 9) nach dem erfindungsgemäßen Sinter/Transferverfahren, Stapeln der mit den Leiterstrukturen ausgestatteten Folienmaterialien 2 und 4 sowie weiterer Folienmaterialien 3, 10 und 10' in der in Fig. 7 dargestellten Reihenfolge und Orientierung zueinander zu einem Folienstapel, und dann Heißpressen des Folienstapels unter Ausbildung des Laminatmaterials 11.

Laminatmaterialien, wie das in Fig. 7 dargestellte, sind beispielsweise zur Herstellung von Folientastaturen geeignet.

Selbstverständlich können in den Laminatmaterialien auch mehrere Funktionen miteinander kombiniert werden. Beispielsweise können Leiterbahnen unterschiedlichster Formen, ein- oder mehrschichtige Spulen, und Schalter in ein und demselben Laminatmaterial enthalten sein. Die erfindungsgemäß mittels Nanotinten im Sinter/Transferverfahren erzeugten Leiterstrukturen eignen sich hervorragend zur Kontaktierung von IC-Chips, da sie sehr geringe Kontaktwiderstände auf üblichen Bondpads aus Gold oder Platin zeigen. Leiterstrukturen in verschiedenen Ebenen eines Laminatmaterials können mit Hilfe gleicher oder verschiedener Nanotinten hergestellt werden.

Zu den besonderen Vorteilen der erfindungsgemäß aus Nanotinten im Sinter/Transferverfahren hergestellten Leiterstrukturen gegenüber unversinterten Leiterstrukturen aus derselben Nanotinte gehören insbesondere
- eine um bis zu 50% bessere Nutzung des metallischen Materials bezüglich Leitfähigkeit,
- eine Reduzierung der Dicke der Leiterstrukturen um bis zu 50%, was Vorteile beim optischen Erscheinungsbild von Chipkarten bewirkt, und außerdem eine unauffällige Unterbringung elektrisch leitfähiger Strukturen in Wertdokumenten ermöglicht,
- eine Reduzierung der Prozessdauer etwa um den Faktor 10, und
- eine optimale Prüfbarkeit der elektrischen Eigenschaften der Leiterstrukturen, insbesondere Spulen, vor der Weiterverarbeitung, insbesondere vor der Chipbestückung.

## Patentansprüche

1. Verfahren zur Ausstattung eines Folienmaterials (2, 3, 4) mit mindestens einer elektrisch leitfähigen Leiterstruktur (5, 6, 7), umfassend folgende Schritte:
(a) Auftragen einer metallische Nanopartikel enthaltenden Dispersion in einer Form, die der Form der auszubildenden Leiterstruktur (5, 6, 7) entspricht, auf eine Oberfläche (31, 36) eines Transfermaterials (30, 35) zur Erzeugung einer von den Nanopartikeln gebildeten Vorläufer-Leiterstruktur (20),
(b) Versintern der die Vorläufer-Leiterstruktur (20) bildenden metallischen Nanopartikel durch Zuführen von Wärme unter Ausbildung der elektrisch leitfähigen Leiterstruktur (5, 6, 7) auf der Oberfläche (31, 36) des Transfermaterials (30, 35),
(c) In Berührung bringen einer Oberfläche (2') des Folienmaterials (2, 3, 4) und der Oberfläche (31, 36) des Transfermaterials (30, 35), auf der sich die elektrisch leitfähige Leiterstruktur (5, 6, 7) befindet,
(d) Übertragen der elektrisch leitfähigen Leiterstruktur (5, 6, 7) durch Ausüben von Druck, und optional Zuführen von Wärme, von der Oberfläche (31, 36) des Transfermaterials (30,35) auf die berührende Oberfläche (2') des Folienmaterials (2, 3, 4), und
(e) Abtrennen von Teilstücken einer gewünschten Größe von dem Folienmaterial (2, 3,4), wobei ein Teilstück mindestens eine elektrisch leitfähige Leiterstruktur (5, 6, 7) aufweist,
**gekennzeichnet dadurch, dass** als Transfermaterial ein Band (30) aus einem hochtemperaturbeständigen Kunststoff oder aus einem mit einem hochtemperaturbeständigen Kunststoff beschichteten Material verwendet wird, wobei der hochtemperaturbeständige Kunststoff Kapton oder ein Perfluoralkoxy-Polymer ist.

2. Verfahren nach Anspruch 1, **dadurch gekennzeichnet, dass** als Transfermaterial eine Walze (35) aus Metall oder aus einem hochtemperaturbeständigen Kunststoff oder eine mit einem hochtemperaturbeständigen Kunststoff oder Metall beschichtete Walze verwendet wird, wobei der hochbeständige Kunststoff bevorzugt Kapton oder ein Perfluoralkoxy-Polymer ist.

3. Verfahren nach einem der Ansprüche 1 bis 2, **dadurch gekennzeichnet, dass** die Nanopartikel enthaltende Dispersion eine wässrige Dispersion oder eine Dispersion auf Lösemittelbasis mit einem Gehalt an Nanopartikeln von 10 Gew.-% bis 30 Gew.-% und/oder mit einem mittleren Partikeldurchmesser der Nanopartikel von 20 nm bis 1000 nm ist, wobei die Nanopartikel Partikel aus Reinmetallen oder aus Metall-Legierungen sind und bevorzugt ausgewählt werden aus der Gruppe, die aus Silber, Aluminium und Kupfer-Nickel-Legierungen besteht.

4. Verfahren nach einem der Ansprüche 1 bis 3, **dadurch gekennzeichnet, dass** das Auftragen der metallischen Nanopartikel enthaltenden Dispersion durch ein Druckverfahren erfolgt, bevorzugt durch ein Druckverfahren, das ausgewählt wird aus der Gruppe, die aus Siebdruck, Flexodruck, Aerosoldruck, Tintenstrahldruck und Gravur-Printing besteht.

5. Verfahren nach einem der Ansprüche 1 bis 4, **dadurch gekennzeichnet, dass** das Versintern der die Vorläufer-Leiterstruktur (20) bildenden Nanopartikel zu der elektrisch leitfähigen Leiterstruktur (5, 6, 7) bei einer Temperatur von mindestens 150°C, bevorzugt mindestens 200°C, besonders bevorzugt mindestens 250°C, und innerhalb einer Zeit von höchstens 30 Sekunden, bevorzugt höchstens 20 Sekunden, besonders bevorzugt höchstens 10 Sekunden, erfolgt.

6. Verfahren nach einem der Ansprüche 1 bis 5, **dadurch gekennzeichnet, dass** als mit den Leiterstrukturen (5, 6, 7) auszustattendes Folienmaterial (2, 3,4) ein heißlaminierbares Folienmaterial, bevorzugt ein Polyester, ein Polycarbonat, ein Polyolefin, ein Polyamid, ein Fluorpolymer oder ein Vinylpölymer, verwendet wird.

7. Verfahren nach einem der Ansprüche 1 bis 6, **dadurch gekennzeichnet, dass** die mit der elektrisch leitfähigen Leiterstruktur (5, 6, 7) auszustattende Oberfläche (2') des Folienmaterials (2, 3, 4) zur Verbesserung der Haftung an der Leiterstruktur haftungsfördernd vorbehandelt oder haftungsfördernd beschichtet wird und/ oder dass die Oberfläche (31, 36) des Transfermaterials (30, 35) zur Verringerung der Haftung an der elektrisch leitfähigen Leiterstruktur (5, 6, 7) haftungsverringernd vorbehandelt oder beschichtet wird.

8. Verfahren zur Herstellung eines Laminatmaterials (11), das mindestens eine Schicht aus einem ersten Folienmaterial (2), eine Schicht aus einem zweiten Folienmaterial (3) und mindestens eine elektrisch leitfähige Leiterstruktur (5) zwischen der Schicht aus dem ersten Folienmaterial (2) und der Schicht aus dem zweiten Folienmaterial (3) aufweist, wobei die Schicht aus dem ersten Folienmaterial (2) und die Schicht aus dem zweiten Folienmaterial (3) elektrisch isolierend und bevorzugt heißlaminierbar sind, **gekennzeichnet durch** folgende Schritte:
- Ausstatten des ersten (2) oder des zweiten (3) Folienmaterials mit der mindestens einen elektrisch leitfähigen Leiterstruktur (5) nach einem Verfahren gemäß einem der Ansprüche 1 bis 7,
- übereinander Anordnen des ersten (2) und des zweiten (3) Folienmaterials dergestalt, dass sich die elektrisch leitfähige Leiterstruktur (5) zwischen dem ersten und dem zweiten Folienmaterial befindet, und
- Verbinden des ersten und des zweiten Folienmaterials zu dem Laminatmaterial (11), bevorzugt **durch** Heißlaminieren.

9. Verfahren nach Anspruch 8, **dadurch gekennzeichnet, dass**
- das erste Folienmaterial (2) nach einem Verfahren gemäß einem der Ansprüche 1 bis 7 mit der Leiterstruktur (5) ausgestattet wird, und das zweite Folienmaterial (3) nach einem Verfahren gemäß einem der Ansprüche 1 bis 7 mit einer Leiterstruktur (6) ausgestattet wird,
- das erste und das zweite Folienmaterial und ein drittes Folienmaterial (4) dergestalt übereinander angeordnet werden, dass sich die Leiterstrukturen (5, 6) jeweils zwischen Schichten aus Folienmaterial befinden und durch eine Schicht aus Folienmaterial voneinander getrennt werden, und
- das erste und das zweite und das dritte Folienmaterial zu dem Laminatmaterial (11) verbunden werden, bevorzugt durch Heißlaminieren.

10. Verfahren nach Anspruch 8 oder 9, **dadurch gekennzeichnet, dass**
- mindestens ein weiteres Folienmaterial nach einem Verfahren gemäß einem der Ansprüche 1 bis 7 mit einer elektrisch leitfähigen Leiterstruktur ausgestattet wird,
- das erste und das zweite und gegebenenfalls dritte und das mindestens eine weitere Folienmaterial dergestalt übereinander angeordnet werden, dass sich die elektrisch leitfähigen Leiterstrukturen jeweils zwischen Schichten aus Folienmaterial befinden und durch eine Schicht aus Folienmaterial voneinander getrennt werden, und
- das erste und das zweite und das dritte und das mindestens eine weitere Folienmaterial zu dem Laminatmaterial (11) verbunden werden, bevorzugt durch Heißlaminieren.

11. Verfahren nach Anspruch 8, **dadurch gekennzeichnet, dass**
- das erste oder das zweite Folienmaterial nach einem Verfahren nach einem der Ansprüche 1 bis 7 an seinen beiden Oberflächen jeweils mit einer elektrisch leitfähigen Leiterstruktur (5, 6) ausgestattet wird,
- das erste und das zweite und ein weiteres Folienmaterial dergestalt übereinander angeordnet werden, dass sich die elektrisch leitfähigen Leiterstrukturen jeweils zwischen zwei Schichten aus Folienmaterial befinden und durch eine Schicht aus Folienmaterial voneinander getrennt werden, und
- das erste und das zweite und das weitere Folienmaterial zu dem Laminatmaterial (11) verbunden werden, bevorzugt durch Heißlaminieren.

12. Verfahren nach Anspruch 8, **dadurch gekennzeichnet, dass**
- das erste Folienmaterial nach einem Verfahren nach einem der Ansprüche 1 bis 7 an einer Oberfläche mit einer ersten und einer zweiten elektrisch leitfähigen Leiterstruktur (5, 6) ausgestattet wird,
- das zweite Folienmaterial nach einem Verfahren nach einem der Ansprüche 1 bis 7 mit einer dritten elektrisch leitfähigen Leiterstruktur (7) ausgestattet wird,
- das erste und das zweite Folienmaterial und ein weiteres Folienmaterial dergestalt übereinander angeordnet werden, dass sich die Leiterstrukturen zwischen Schichten aus Folienmaterial befinden und die erste und zweite Leiterstruktur durch das weitere Folienmaterial voneinander getrennt werden, und
- das erste und das zweite und das weitere Folienmaterial zu dem Laminatmaterial (11) verbunden werden, bevorzugt durch Heißlaminieren.

13. Verfahren nach einem der Ansprüche 8 bis 12, **dadurch gekennzeichnet, dass** mindestens eine der Schichten aus Folienmaterial eine durchgehende Öffnung aufweist, wobei es die durchgehende Öffnung gegebenenfalls erlaubt, einander gegenüberliegende elektrisch leitfähige Leiterstrukturen miteinander in Kontakt zu bringen.

## Claims

1. A method for equipping a foil material (2, 3, 4) with at least one electrically conductive conductor structure (5, 6, 7), comprising the following steps:
(a) applying a dispersion, containing metallic nanoparticles, in a form which corresponds to the form of the conductor structure (5, 6, 7) to be formed, to a surface (31, 36) of a transfer material (30, 35) for producing a precursor conductor structure (20) formed by the nanoparticles,
(b) sintering the metallic nanoparticles forming the precursor conductor structure (20) by supplying heat so as to form the electrically conductive conductor structure (5, 6, 7) on the surface (31, 36) of the transfer material (30, 35),
(c) bringing in touch a surface (2') of the foil material (2, 3, 4) and the surface (31, 36) of the transfer material (30, 35) on which the electrically conductive conductor structure (5, 6, 7) is located,
(d) transferring the electrically conductive conductor structure (5, 6, 7) from the surface (31, 36) of the transfer material (30, 35) onto the touching surface (2') of the foil material (2, 3, 4) by exerting pressure, and optionally supplying heat, and
(e) detaching segments of a desired size from the foil material (2, 3, 4), a segment having at least one electrically conductive conductor structure (5, 6, 7),
**characterized in that** as a transfer material there is employed a band (30) made of a high-temperature-resistant plastic or of a material coated with a high-temperature-resistant plastic, wherein the high-temperature-resistant plastic is Kapton or a perfluoroalkoxy polymer.

2. The method according to claim 1, **characterized in that** as a transfer material there is employed a roller (35) made of metal or of a high-temperature-resistant plastic or a roller coated with a high-temperature-resistant plastic or metal, wherein the highly resistant plastic preferably is Kapton or a perfluoroalkoxy polymer.

3. The method according to any of claims 1 to 2, **characterized in that** the dispersion containing nanoparticles is an aqueous dispersion or a solvent-based dispersion with a content of nanoparticles of 10 wt% to 30 wt% and/or with an average particle diameter of the nanoparticles of 20 nm to 1000 nm, wherein the nanoparticles are particles of pure metals or of metal alloys and are preferably chosen from the group consisting of silver, aluminum and copper-nickel alloys.

4. The method according to any of claims 1 to 3, **characterized in that** the application of the dispersion containing metallic nanoparticles is effected by a printing method, preferably by a printing method that is chosen from the group consisting of screen printing, flexographic printing, aerosol printing, inkjet printing and gravure printing.

5. The method according to any of claims 1 to 4, **characterized in that** the sintering of the nanoparticles forming the precursor conductor structure (20) into the electrically conductive conductor structure (5, 6, 7) is effected at a temperature of at least 150°C, preferably at least 200°C, particularly preferably at least 250°C, and within a time of no more than 30 seconds, preferably no more than 20 seconds, particularly preferably no more than 10 seconds.

6. The method according to any of claims 1 to 5, **characterized in that** as the foil material (2, 3, 4) to be equipped with the conductor structures (5, 6, 7) there is employed a hot-laminatable foil material, preferably a polyester, a polycarbonate, a polyolefin, a polyamide, a fluoropolymer or a vinyl polymer.

7. The method according to any of claims 1 to 6, **characterized in that** the foil material's (2, 3, 4) surface (2') to be equipped with the electrically conductive conductor structure (5, 6, 7) is pretreated in adhesion-enhancing fashion or coated in adhesion-enhancing fashion for improving the adhesion to the conductor structure and/or that the surface (31, 36) of the transfer material (30, 35) is pretreated or coated in adhesion-reducing fashion for reducing the adhesion to the electrically conductive conductor structure (5, 6, 7).

8. A method for manufacturing a laminate material (11) which has at least a layer made of a first foil material (2), a layer made of a second foil material (3) and at least one electrically conductive conductor structure (5) between the layer made of the first foil material (2) and the layer made of the second foil material (3), wherein the layer made of the first foil material (2) and the layer made of the second foil material (3) are electrically insulating and preferably hot-laminatable, **characterized by** the following steps:
- equipping the first (2) or the second (3) foil material with the at least one electrically conductive conductor structure (5), in accordance with a method according to any of the claims 1 to 7,
- arranging the first (2) and the second (3) foil material on top of each other in such a way that the electrically conductive conductor structure (5) is located between the first and the second foil material, and
- connecting the first and the second foil material into the laminate material (11), preferably through hot lamination.

9. The method according to claim 8, **characterized in that**
- the first foil material (2) is equipped with the conductor structure (5), in accordance with a method according to any of claims 1 to 7, and the second foil material (3) is equipped with a conductor structure (6), in accordance with a method according to any of claims 1 to 7,
- the first and the second foil material and a third foil material (4) are arranged on top of each other in such a way that the conductor structures (5, 6) are respectively located between layers made of foil material and are separated from each other by a layer made of foil material, and
- the first and the second and the third foil material are connected into the laminate material (11), preferably through hot lamination.

10. The method according to claim 8 or 9, **characterized in that**
- at least one further foil material is equipped with an electrically conductive conductor structure, in accordance with a method according to any of claims 1 to 7,
- the first and the second and, where applicable, third and the at least one further foil material are arranged on top of each other in such a way that the electrically conductive conductor structures are respectively located between layers made of foil material and are separated from each other by a layer made of foil material, and
- the first and the second and the third and the at least one further foil material are connected into the laminate material (11), preferably through hot lamination.

11. The method according to claim 8, **characterized in that**
- the first or the second foil material is respectively equipped on its two surfaces with an electrically conductive conductor structure (5, 6), in accordance with a method according to any of claims 1 to 7,
- the first and the second and a further foil material are arranged on top of each other in such a way that the electrically conductive conductor structures are respectively located between two layers made of foil material and are separated from each other by a layer made of foil material, and
- the first and the second and the further foil material are connected into the laminate material (11), preferably through hot lamination.

12. The method according to claim 8, **characterized in that**
- the first foil material is equipped on a surface with a first and a second electrically conductive conductor structure (5, 6), in accordance with a method according to any of claims 1 to 7,
- the second foil material is equipped with a third electrically conductive conductor structure (7), in accordance with a method according to any of claims 1 to 7,
- the first and the second foil material and a further foil material are arranged on top of each other in such a way that the conductor structures are located between layers made of foil material and the first and second conductor structure are separated from each other by the further foil material, and
- the first and the second and the further foil material are connected into the laminate material (11), preferably through hot lamination.

13. The method according to any of claims 8 to 12, **characterized in that** at least one of the layers made of foil material has a through opening, wherein the through opening allows, where applicable, to contact mutually opposing electrically conductive conductor structures with each other.

## Revendications

1. Procédé d'équipement d'un matériau film (2, 3, 4) avec au moins une structure à conducteur (5, 6, 7) électriquement conductrice, comprenant les étapes suivantes:
(a) Application d'une dispersion contenant des nanoparticules métalliques sous une forme qui correspond à la forme de la structure à conducteur (5, 6, 7) à réaliser, sur une surface (31, 36) d'un matériau de transfert (30, 35) pour la génération d'un précurseur de structure à conducteur (20) constitué de nanoparticules,
(b) Frittage des nanoparticules métalliques constituant le précurseur de structure à conducteur (20) par apport de chaleur de façon à réaliser la structure à conducteur (5, 6, 7) électriquement conductrice sur la surface (31, 36) du matériau de transfert (30, 35),
(c) Mise en contact d'une surface (2') du matériau film (2, 3, 4) et de la surface (31, 36) du matériau de transfert (30, 35) sur laquelle se trouve la structure à conducteur (5, 6, 7) électriquement conductrice,
(d) Transposition de la structure à conducteur (5, 6, 7) électriquement conductrice par l'exercice d'une pression et, en option, par apport de chaleur, de la surface (31, 36) du matériau de transfert (30, 35) à la surface de contact (2') du matériau film (2, 3, 4), et
(e) Prélèvement de fragments d'une taille souhaitée du matériau film (2, 3, 4), un fragment comportant au moins une structure à conducteur (5, 6, 7) électriquement conductrice,
**caractérisé en ce que**, en tant que matériau de transfert, un ruban (30) en une matière plastique résistant aux hautes températures ou en un matériau revêtu avec une matière plastique résistant aux hautes températures est utilisé, la matière plastique résistant aux hautes températures étant du kapton ou un polymère perfluoralkoxy.

2. Procédé selon la revendication 1, **caractérisé en ce que**, en tant que matériau de transfert, un rouleau (35) en métal ou en une matière plastique résistant aux hautes températures ou bien un rouleau revêtu avec une matière plastique ou métal résistant aux hautes températures est utilisé, la matière plastique à haute résistance étant de préférence du kapton ou un polymère perfluoralkoxy.

3. Procédé selon une des revendications de 1 à 2, **caractérisé en ce que** la dispersion contenant les nanoparticules est une dispersion aqueuse ou une dispersion à base de solvant ayant une teneur en nanoparticules de 10 pourcent par poids à 30 pourcent par poids et/ou dont les nanoparticules ont un diamètre moyen de nanoparticules situé entre 20 nm et 1000 nm, les nanoparticules étant des particules en métaux purs ou en alliages de métaux et étant de préférence choisies dans le groupe constitué d'alliages d'argent, d'aluminium et de cuivre-nickel.

4. Procédé selon une des revendications de 1 à 3, **caractérisé en ce que** l'application de la dispersion contenant des nanoparticules métalliques a lieu par un procédé d'impression, de préférence par un procédé d'impression qui est choisi dans le groupe constitué de sérigraphie, flexographie, impression aérosol, impression par jet d'encre et héliogravure.

5. Procédé selon une des revendications de 1 à 4, **caractérisé en ce que** le frittage des nanoparticules constituant le précurseur de structure à conducteur (20) aboutissant à la structure à conducteur (5, 6, 7) électriquement conductrice a lieu à une température d'au moins 150°C, de préférence d'au moins 200°C, particulièrement de préférence d'au moins 250°C et dans un laps de temps d'au maximum 30 secondes, de préférence d'au maximum 20 secondes, particulièrement de préférence d'au maximum 10 secondes.

6. Procédé selon une des revendications de 1 à 5, **caractérisé en ce que**, en tant que matériau film (2, 3, 4) à équiper avec les structures à conducteur (5, 6, 7), c'est un matériau film se prêtant au laminage à chaud, de préférence un polyester, un polycarbonate, une polyoléfine, un polyamide, un polymère fluoré ou un polymère vinylique qui est utilisé.

7. Procédé selon une des revendications de 1 à 6, **caractérisé en ce que** la surface (2') du matériau film (2, 3, 4) à équiper avec la structure à conducteur (5, 6, 7) électriquement conductrice est, pour améliorer l'adhérence à la structure à conducteur, pré-traitée de manière favorisant l'adhérence ou revêtue de manière favorisant l'adhérence et/ou **en ce que** la surface (31, 36) du matériau de transfert (30, 35) est, pour réduire l'adhérence à la structure à conducteur (5, 6, 7) électriquement conductrice, pré-traitée ou revêtue de manière réduisant l'adhérence.

8. Procédé de fabrication d'un matériau stratifié (11) qui comporte au moins une couche en un premier matériau film (2), une couche en un deuxième matériau film (3) et au moins une structure à conducteur (5) électriquement conductrice entre la couche en le premier matériau film (2) et la couche en le deuxième matériau film (3), la couche en le premier matériau film (2) et la couche en le deuxième matériau film (3) étant électriquement isolantes et se prêtant de préférence au laminage à chaud, **caractérisé par** les étapes suivantes:
- équipement du premier (2) ou du deuxième (3) matériau film avec la au moins une structure à conducteur (5) électriquement conductrice suivant un procédé selon une des revendications de 1 à 7,
- agencement l'un sur l'autre du premier (2) et du deuxième (3) matériau film de telle manière que la structure à conducteur (5) électriquement conductrice se trouve entre le premier et le deuxième matériau film, et
- jonction du premier et du deuxième matériau film de manière à obtenir le matériau stratifié (11), de préférence par laminage à chaud.

9. Procédé selon la revendication 8, **caractérisé en ce que**
- le premier matériau film (2) est, suivant un procédé selon une des revendications de 1 à 7, équipé de la structure à conducteur (5), et le deuxième matériau film (3) est, suivant un procédé selon une des revendications de 1 à 7, équipé d'une structure à conducteur (6),
- le premier et le deuxième matériau film et un troisième matériau film (4) sont agencés de telle manière les uns au-dessus des autres que les structures à conducteur (5, 6) se trouvent respectivement entre des couches en matériau film et sont séparées les unes des autres par une couche en matériau film, et
- le premier et le deuxième et le troisième matériau film sont joints de manière à obtenir le matériau stratifié (11), de préférence par laminage à chaud.

10. Procédé selon la revendication 8 ou 9, **caractérisé en ce que**
- au moins un matériau film supplémentaire est, suivant un procédé selon une des revendications de 1 à 7, équipé d'une structure à conducteur électriquement conductrice,
- le premier et le deuxième et, le cas échéant, le troisième matériau film et le moins un matériau film supplémentaire sont agencés de telle manière les uns au-dessus des autres que les structures à conducteur électriquement conductrices se trouvent respectivement entre des couches en matériau film et sont séparées les unes des autres par une couche en matériau film, et
- le premier et le deuxième et le troisième matériau film et le moins un matériau film supplémentaire sont joints de manière à obtenir le matériau stratifié (11), de préférence par laminage à chaud.

11. Procédé selon la revendication 8, **caractérisé en ce que**
- le premier ou le deuxième matériau film est, suivant un procédé selon une des revendications de 1 à 7, équipé sur ses deux surfaces respectivement d'une structure à conducteur (5, 6) électriquement conductrice,
- le premier et le deuxième matériau film et un matériau film supplémentaire sont agencés de telle manière les uns au-dessus des autres que les structures à conducteur électriquement conductrices se trouvent respectivement entre deux couches en matériau film et sont séparées les unes des autres par une couche en matériau film, et
- le premier et le deuxième matériau film et le matériau film supplémentaire sont joints de manière à obtenir le matériau stratifié (11), de préférence par laminage à chaud.

12. Procédé selon la revendication 8, **caractérisé en ce que**
- le premier matériau film est, suivant un procédé selon une des revendications de 1 à 7, équipé, sur une surface, d'une première et d'une deuxième structure à conducteur (5, 6) électriquement conductrice,
- le deuxième matériau film est, suivant un procédé selon une des revendications de 1 à 7, équipé d'une troisième structure à conducteur (7) électriquement conductrice,
- le premier et le deuxième matériau film et un matériau film supplémentaire sont agencés de telle manière les uns au-dessus des autres que les structures à conducteur se trouvent entre des couches en matériau film et que la première et deuxième structures à conducteur sont séparées l'une de l'autre par la couche en matériau film supplémentaire, et
- le premier et le deuxième matériau film et le matériau film supplémentaire sont joints de manière à obtenir le matériau stratifié (11), de préférence par laminage à chaud.

13. Procédé selon une des revendications de 8 à 12, **caractérisé en ce qu'**au moins une des couches en matériau film comporte une ouverture continue, l'ouverture continue permettant le cas échéant de mettre en contact entre elles des structures à conducteur électriquement conductrices se faisant face.
